(19) Europäisches Patentamt
European Patent Office
Office européen des brevets

(11) **EP 4 478 562 A2**

(12) **EUROPEAN PATENT APPLICATION**

(43) Date of publication:
**18.12.2024 Bulletin 2024/51**

(21) Application number: **24175865.5**

(22) Date of filing: **15.05.2024**

(51) International Patent Classification (IPC):
*H01S 5/02* (2006.01)  *H01S 5/02315* (2021.01)
*H01S 5/024* (2006.01)  *G01S 7/481* (2006.01)

(52) Cooperative Patent Classification (CPC):
**G01S 7/4814; H01S 5/0206; H01S 5/02315; H01S 5/02469**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.05.2023 CN 202310596059**
**24.05.2023 CN 202310604242**

(71) Applicant: **Suteng Innovation Technology Co., Ltd.**
**Shenzhen City Guangdong 518000 (CN)**

(72) Inventors:
• **Shen, Dan**
**Shenzhen, 518000 (CN)**
• **Lei, Youxue**
**Shenzhen, 518000 (CN)**
• **Zhou, Yue**
**Shenzhen, 518000 (CN)**
• **Wang, Jiadi**
**Shenzhen, 518000 (CN)**

(74) Representative: **RGTH**
**Patentanwälte PartGmbB**
**Neuer Wall 10**
**20354 Hamburg (DE)**

(54) **EMITTER, EMITTING MODULE, AND LIDAR**

(57) The embodiments of the present application disclose an emitter, an emitting module, and a LiDAR. The emitter includes a laser, a driving circuit, a substrate, and a heat conduction member. The laser and the driving circuit are both mounted on the substrate, and the heat conduction member is connected to the substrate, with at least the portion of the substrate used for mounting the laser being in contact with the heat conduction member. Mounting the laser on the substrate and having at least the portion of the substrate used for mounting the laser in contact with the heat conduction member facilitates timely and efficient heat dissipation from the laser through the heat conduction member, improving the heat dissipation rate around the laser and avoiding local hot spots at the laser, thereby ensuring the normal operation of the laser.

Figure 2

## Description

TECHNICAL FIELD

The present application relates to the field of laser detection technology, and particularly to an emitter, an emitting module, and a LiDAR system.

BACKGROUND

LiDAR (Light Detection and Ranging) is a radar system that uses emitted laser beams to detect the position, velocity, and other characteristics of a target. Emit detection light towards the target and then compare the received echo light reflected from the target with a local oscillator light. After appropriate processing, relevant information about the target can be obtained, such as target distance, azimuth, altitude, velocity, attitude, and even shape parameters.

The laser, which is used to emit the detection light, is an essential component of the LiDAR system. With the increasing power density of lasers, their heat dissipation capability has gradually become a key issue limiting the performance of LiDAR systems. It is not easy for the laser to dissipate heat effectively, leading to the formation of local hot spots at the laser and affecting its normal operation.

LiDAR systems typically consist of an emitting module, a receiving module, a scanning module, and other components. Each module generates heat during normal operation.

SUMMARY

The embodiments of the present application provide an emitter, an emitting module, and a LiDAR system, aiming to address the issue where the laser's heat is not easily dissipated, leading to the formation of local hot spots at the laser and affecting its normal operation.

In a first aspect, embodiments of the present application provide an emitter, including: a laser; a driving circuit, electrically connected to the laser; a substrate, on which the laser and the driving circuit are both mounted; a heat conduction member, connected to the substrate, with a portion of the substrate used for mounting the laser being in contact with the heat conduction member.

In some embodiments, the substrate includes: a first substrate, on which the laser is mounted, and the first substrate in contact with the heat conduction member; a second substrate, on which the driving circuit is mounted.

In some embodiments, the second substrate is formed with a mounting opening, and the first substrate is located in the mounting opening. A thermal conductivity of the second substrate is lower than a thermal expansion coefficient of the first substrate, and the second substrate is in contact with the heat conduction member.

In some embodiments, the heat conduction member is located on the side of the substrate where the laser is arranged, and the heat conduction member avoids the laser.

In some embodiments, the thermal expansion coefficient of the heat conduction member is $a$, the thermal expansion coefficient of the first substrate is b, and the emitter satisfies the following condition:

$$3\,\mathrm{ppm/^{\circ}C} \leqslant |a - b| \leqslant 4\,\mathrm{ppm/^{\circ}C}.$$

In some embodiments, a preparation material of the first substrate includes at least one of aluminum nitride, silicon carbide, and copper, and the preparation material of the heat conduction member includes a tungsten-copper alloy.

In some embodiments, the heat conduction member includes: a first main board, located on the side of the substrate where the laser is arranged, and the first main board is provided with a light emitting port; at least one first convex portion, arranged between the first main board and the substrate, corresponding to the first substrate, and the side of the first convex portion away from the first main board is in contact and connected with the first substrate; at least one second convex portion, arranged between the first main board and the substrate, corresponding to the second substrate, and the side of the second convex portion away from the first main board is in contact and connected with the second substrate.

In some embodiments, the heat conduction member is provided with a first mounting hole at the first convex portion, the first substrate is provided with a second mounting hole corresponding to the first mounting hole, and the heat conduction member and the first substrate are connected via a first structural member passing through the first mounting hole and the second mounting hole; and/or

the heat conduction member is provided with a third mounting hole at the second convex portion, the second substrate is provided with a fourth mounting hole corresponding to the third mounting hole, and the heat conduction member and the second substrate are connected via a second structural member passing through the third mounting hole and the fourth mounting hole.

In some embodiments, a shielding member is further included, used to cover the driving circuit and connected to the second substrate.

In some embodiments, part of the driving circuit is mounted on the side of the second substrate close to the laser, and the remaining part of the driving circuit is mounted on the side of the second substrate away from the laser; the shielding member includes two shielding covers, respectively located on the side of the second substrate close to the laser and the side of the second substrate away from the laser. One of the two shielding covers, on the side close to the laser, avoids the laser.

In some embodiments, the shielding cover includes: a connecting portion, connected to the second substrate, and provided with either a snapping member or a fastening member; a shielding portion, provided with the other of the snapping member and the fastening member, and the snapping member and the fastening member are detachably connected.

In some embodiments, the connecting portion includes a first connecting plate and a second connecting plate. The middle portion of the first connecting plate is hollowed out, and the first connecting plate is spaced apart from the second substrate. One end of the second connecting plate is connected to the first connecting plate, and the other end of the second connecting plate is bent relative to the first connecting plate and extends towards the second substrate for connection with the second substrate. The second connecting plate is provided with either a snapping member or a fastening member; and/or the shielding portion includes a first shielding plate and a second shielding plate. The first shielding plate is located on the side of the connecting portion away from the second substrate and covers the connecting portion. One end of the second shielding plate is connected to the first shielding plate, and the other end of the second shielding plate is bent relative to the first shielding plate and extends towards the second substrate. The second shielding plate is provided with the other of the snapping member and the fastening member.

In some embodiments, the first substrate and the heat conduction member are integrally formed.

In some embodiments, the heat conduction member includes: a first heat conduction plate, located on a side of the substrate where the laser is arranged, and the first heat conduction plate avoids the laser; a second heat conduction plate, located on a side of the substrate away from the laser; wherein a portion of the driving circuit is mounted on the side of the second substrate close to the laser and is covered by the first heat conduction plate, and a remaining portion of the driving circuit is mounted on the side of the second substrate away from the laser and is covered by the second heat conduction plate.

Both the first heat conduction plate and the second heat conduction plate are metal members. The first heat conduction plate is in contact with the second substrate, and the second heat conduction plate is in contact with the first substrate and the second substrate.

In some embodiments, a thermal expansion coefficient of the second heat conduction plate is c, a thermal expansion coefficient of the first substrate is b, and the emitter satisfies the following condition:

$$3\,ppm/^{\circ}C \leqslant |c-b| \leqslant 4\,ppm/^{\circ}C.$$

In some embodiments, the preparation material of the first substrate includes at least one of aluminum nitride, silicon carbide, and copper, and a preparation material of the second heat conduction plate includes a tungsten-copper alloy.

In some embodiments, the second heat conduction plate includes: a second main board, located on the side of the substrate away from the laser and covering the driving circuit on that side; a third convex portion, arranged between the second main board and the substrate, corresponding to the first substrate, and in contact with the first substrate.

In a second aspect, the embodiments of the present application provide an emitting module, including: the aforementioned emitter; an emitting lens, located on the light emitting side of the laser on the emitter.

In some embodiments, the heat conduction member is in contact and connected with the emitting lens.

In some embodiments, a heat transfer member is further included, which includes a first heat transfer plate and a second heat transfer plate. The first heat transfer plate is located on the side of the emitter away from the emitting lens and is in contact with the emitter. One end of the second heat transfer plate is connected to the first heat transfer plate, and the other end of the second heat transfer plate extends towards the emitting lens. The second heat transfer plate is in contact with both the first heat transfer plate and the emitting lens.

In a third aspect, the embodiments of the present application provide a LiDAR system, including: the aforementioned emitting module; a housing, in which the emitting module is mounted. The emitting lens is in contact with the housing, and/or the heat conduction member is in contact with the housing.

The emitter, emitting module, and LiDAR system of the present application mount the laser on the substrate and have at least the portion of the substrate used for mounting the laser in contact with the heat conduction member. This facilitates timely and efficient heat dissipation from the laser through the heat conduction member, improving the heat dissipation rate around the laser and avoiding local hot spots at the laser, thereby ensuring the normal operation of the laser.

Embodiments of the present application provide a LiDAR that addresses the issue of heat dissipation from the emitting module, receiving module, and scanning module within the LiDAR system.

Embodiments of the present application provide a LiDAR, including: a housing, forming an accommodating cavity; an emitting module, located in the accommodating cavity, used to output detection light; a receiving module, located within the accommodating cavity; a scanning module, located in the accommodating cavity, used to receive the detection light and transmit it to a target object, and also used to receive the echo light reflected from the target object by the detection light and transmit the echo light to the receiving module; wherein the emitting module, the receiving module, and the scanning module are thermally connected to different parts of the housing.

In an embodiment, wherein the housing is formed with a window that is communicated with the accommodating cavity, and the LiDAR further comprises: a window piece, wherein the window piece covers the window and is connected to the housing, and along a direction of transmission of the detection light, the window piece is located downstream of the scanning module, and along a direction of transmission of the echo light, the window piece is located upstream of the scanning module, and the scanning module is located closer to the window piece than the emitting module, the scanning module is located closer to the window piece than the receiving module, and the emitting module and the receiving module are spaced apart.

In an embodiment, wherein the housing comprises: a first end plate; a second end plate, wherein the second end plate is opposite to the first end plate and is spaced apart from the first end plate, and a peripheral side plate, wherein the peripheral side plate is connected to the first end plate and the second end plate, and the first end plate, the second end plate, and the peripheral side plate enclose the accommodating cavity, and the first end plate is in heat conduction connection with the emitting module, the second end plate is in heat conduction connection with the emitting module, and the peripheral side plate is in heat conduction connection with the emitting module.

In an embodiment, wherein the emitting module comprises: an emitting board, wherein the emitting board is used to output the detection light, and an emitting lens, wherein the emitting lens is used to receive the detection light and to transmit the detection light to the scanning module, and the emitting board is in heat conduction connection with the housing, the emitting board is in heat conduction connection with the emitting lens, and the emitting lens is in heat conduction connection with the housing.

In an embodiment, wherein the emitting module further comprises: an emitting heat conduction member, wherein the emitting heat conduction member comprises a first heat conduction plate and a second heat conduction plate, the first heat conduction plate is located on a side of the emitting board that is away from the emitting lens, and the first heat conduction plate is in heat conduction connection with the emitting board, and an end of the second heat conduction plate is connected to the first heat conduction plate, the second heat conduction plate extends in a direction towards the emitting lens, and the second heat conduction plate is in heat conduction connection with the emitting lens.

In an embodiment, wherein the emitting board comprises: a laser; an emitting driving circuit, wherein the emitting driving circuit is electrically connected to the laser, and an emitting substrate, wherein the emitting substrate comprises a first substrate and a second substrate, the laser is mounted on the first substrate, and the emitting driving circuit is mounted on the second substrate, and the heat conduction member is in heat conduction connection with the first substrate.

In an embodiment, wherein the second substrate is formed with a mounting opening, the first substrate is located in the mounting opening, a thermal expansion coefficient of the second substrate is lower than a thermal expansion coefficient of the first substrate, and the second substrate is in heat conduction connection with the heat conduction member.

In an embodiment, wherein the heat conduction member is located between the emitting substrate and the emitting lens, the heat conduction member is in heat conduction connection with the first substrate, the second substrate, and the emitting lens, and the heat conduction member avoids the laser, and the emitting module further comprises an emitting shielding member, and the emitting shielding member covers the emitting driving circuit, or the heat conduction member comprises a first heat conduction plate that is located between the emitting substrate and the emitting lens, and a second heat conduction plate that is located on a side of the emitting substrate that is away from the emitting lens, the first heat conduction plate avoids the laser, the first heat conduction plate is in heat conduction connection with the second substrate and the emitting lens, the second heat conduction plate is in heat conduction connection with the first substrate and the second substrate, the first heat conduction plate and the second heat conduction plate cover the emitting driving circuit, the first heat conduction plate and the second heat conduction plate are both metal members.

In an embodiment, wherein the emitting module is in heat conduction connection with the first end plate and the second end plate of the housing.

In an embodiment, wherein the emitting module is in heat conduction connection with the second end plate of the housing, and the LiDAR further comprises: a functional board, wherein the functional board is located between the emitting module and the second end plate, the functional board is formed with an avoiding hole that corresponds to the emitting module, and the emitting module passes through the avoiding hole.

In an embodiment, wherein a functional shielding cover is located on the functional board, one side of the functional shielding cover is in heat conduction connection with the functional board, and the other side of the functional shielding cover is in heat conduction connection with the second end plate.

In an embodiment, wherein the receiving module comprises: a receiving board, wherein the receiving board is used to receive the echo light, and a receiving shielding member, wherein the receiving shielding member covers the receiving board, and the receiving shielding member is in heat conduction connection with the first end plate and the second end plate of the housing.

In an embodiment, wherein the receiving board comprises: a receiver, wherein the receiver is used to receive the detection light, and a receiving substrate, wherein the receiver is mounted on one side of the receiving substrate, and a metal through hole is formed at a position on the receiving substrate that corresponds to the receiver, and the receiving shielding member comprises a first receiving shielding cover, the first receiving shielding cover is located on a side of the receiving substrate that is away from the receiver, a first convex platform is formed at a position on the first receiving shielding cover that corresponds to the receiver, the first convex platform is in heat conduction connection with the receiving substrate, and the first receiving shielding cover is in heat conduction connection with the first end plate and the second end plate.

In an embodiment, wherein the first receiving shielding cover is located on a side of the receiving substrate that is away from the receiver, a first receiving driving circuit is located on a side of the receiving substrate that is away from the receiver, and the first receiving shielding cover covers the first receiving driving circuit, and the receiving module further comprises a signal amplification board, the signal amplification board is located on a side of the first receiving shielding cover that is away from the receiving substrate, the signal amplification board is electrically connected to the receiving board, a second receiving driving circuit is located on a side of the signal amplification board that is close to the first receiving shielding cover, and the first receiving shielding cover covers the second receiving driving circuit.

In an embodiment, wherein the scanning module comprises: a scanning piece, wherein the scanning piece comprises a scanner and an electronic control board, the scanner is mounted on the electronic control board and is electrically connected to the electronic control board, and the electronic control board is in heat conduction connection with the first end plate or the second end plate of the housing, or the scanning piece further comprises a scanning shielding member and a scanning heat conduction member, the scanning shielding member comprises a third heat conduction plate and a fourth heat conduction plate that is connected to the third heat conduction plate, the third heat conduction plate is located on the electronic control board and is in heat conduction connection with the electronic control board, the fourth heat conduction plate is arranged at an angle with the third heat conduction plate and is in heat conduction connection with the peripheral side plate.

In an embodiment, wherein the scanning module comprises two scanning pieces, the rotating axes of the scanners of the two scanning pieces intersect, the electronic control board of one of the scanning pieces is located close to the first end plate and is in heat conduction connection with the first end plate, the electronic control board of the other scanning piece is located close to the second end plate, and the electronic control board of the other scanning piece is in heat conduction connection with the peripheral side plate via the scanning shielding member and the scanning heat conduction member.

The LiDAR of the embodiments thermally connects the emitting module, the receiving module, and the scanning module to the housing, enabling timely dissipation of the heat generated by these modules during operation through the housing, ensuring the safe and stable operation of the LiDAR.

The emitting module, the receiving module, and the scanning module are thermally connected to different parts of the housing, allowing the heat generated by these modules to be dissipated outward through different parts of the housing, avoiding local heat concentration on the housing that could affect the heat dissipation rate.

## BRIEF DESCRIPTION OF DRAWINGS

To illustrate the technical solutions of the embodiments of the present application or the prior art more clearly, a brief introduction to the accompanying drawings used in the description of the embodiments or the prior art is provided below.

Figure 1 is a structural schematic diagram of an emitter provided by an embodiment.
Figure 2 is an exploded structural schematic diagram of the emitter shown in Figure 1.
Figure 3 is a structural schematic diagram of the emitter shown in Figure 1.
Figure 4 is an exploded structural schematic diagram of the emitter shown in Figure 3.
Figure 5 is a structural schematic diagram of an emitter provided by an embodiment.
Figure 6 is a structural schematic diagram of the emitter shown in Figure 5.
Figure 7 is a structural schematic diagram of one shielding cover in the emitter shown in Figure 5.
Figure 8 is a structural schematic diagram of another shielding cover in the emitter shown in Figure 5.
Figure 9 is an exploded structural schematic diagram of an emitter provided by an embodiment.
Figure 10 is an exploded structural schematic diagram of the emitter shown in Figure 9.
Figure 11 is a structural schematic diagram of an emitting module corresponding to the emitter shown in Figure 9.
Figure 12 is a structural schematic diagram of an emitting module corresponding to the emitter shown in Figure 5.
Figure 13 is a partial sectional structural schematic diagram of the emitting module shown in Figure 12.
Figure 14 is a partial sectional structural schematic diagram of a LiDAR corresponding to the emitting module shown in Figure 12.
Figure 15 is a top view of a LiDAR provided by an embodiment.
Figure 16 is a partial sectional view of Figure 15 in the A-A direction.
Figure 17 is a partial sectional view of Figure 16 in the B-B direction.
Figure 18 is an exploded structural schematic diagram of the LiDAR shown in Figure 1.
Figure 19 is a structural schematic diagram of an emitting module in a LiDAR provided by an embodiment.

Figure 20 is a sectional structural schematic diagram of the emitting module shown in Figure 19.

Figure 21 is a structural schematic diagram of an emitter in the emitting module shown in Figure 19.

Figure 22 is an exploded structural schematic diagram of the emitter in the emitting module shown in Figure 19.

Figure 23 is a structural schematic diagram of the emitter in the emitting module shown in Figure 19.

Figure 24 is an exploded structural schematic diagram of the emitter in the emitting module shown in Figure 19.

Figure 25 is a structural schematic diagram of an emitter in an emitting module of a LiDAR provided by an embodiment.

Figure 26 is a structural schematic diagram of the emitter shown in Figure 25.

Figure 27 is a structural schematic diagram of one shielding cover in the emitter shown in Figure 25.

Figure 28 is a structural schematic diagram of another shielding cover in the emitter shown in Figure 25.

Figure 29 is a structural schematic diagram of an emitting module in a LiDAR provided by an embodiment.

Figure 30 is an exploded structural schematic diagram of an emitter in the emitting module shown in Figure 29.

Figure 31 is an exploded structural schematic diagram of the emitter in the emitting module shown in Figure 29.

Figure 32 is an exploded structural schematic diagram of a receiving module in a LiDAR provided by an embodiment.

Figure 33 is an exploded structural schematic diagram of the receiving module shown in Figure 32.

Description of Reference Numerals in the Drawings:

10: emitter; 11: laser; 12: driving circuit; 13: substrate; 131: first substrate; 1311: first electrical connection pad; 1312: first plate surface; 1313: second plate surface; 1314: second mounting hole; 132: second substrate; 1321: mounting opening; 1322: second electrical connection pad; 1323: third plate surface; 1324: fourth plate surface; 1325: fourth mounting hole; 14: heat conduction member; 141: first heat conduction plate; 1411: light emitting port; 1412: first main board; 1413: first convex portion; 1414: second convex portion; 1415: first mounting hole; 1416: third mounting hole; 142: second heat conduction plate; 1421: second main board; 1422: third convex portion; 1423: fourth convex portion; 15: shielding member; 151: shielding cover; 1511: connecting portion; 1512: shielding portion; 1513: snapping member; 1514: fastening member; 1515: first connecting plate; 1516: second connecting plate; 1517: first shielding plate; 1518: second shielding plate; 20: emitting lens; 21: first structural member; 22: sixth mounting hole; 30: heat transfer member; 31: first heat transfer plate; 32: second heat transfer plate; 100: LiDAR; 200: emitting module; 300: housing; 310: first end plate; 320: second end plate; 330: peripheral side plate; 400: functional board; 410: bypass hole.

1: LiDAR; 100: emitting module; 13: emitting substrate; 131: first substrate; 1311: first electrical connection pad; 1312: first plate surface; 1313: second plate surface; 1314: second mounting hole; 132: second substrate; 1321: mounting opening; 1322: second electrical connection pad; 1323: third plate surface; 1324: fourth plate surface; 1325: fourth mounting hole; 14: heat conduction member; 141: first heat conduction plate; 1411: light emitting port; 1412: first main board; 1413: first convex portion; 1414: second convex portion; 1415: first mounting hole; 1416: third mounting hole; 142: second heat conduction plate; 1421: second main board; 1422: third convex portion; 1423: fourth convex portion; 15: emitting shielding member; 151: emitting shielding cover; 1511: connecting portion; 1512: shielding portion; 1513: snapping member; 1514: fastening member; 1515: first connecting plate; 1516: second connecting plate; 1517: first shielding plate; 1518: second shielding plate; 20: emitting lens; 21: first structural member; 22: sixth mounting hole; 30: emitting heat transfer member; 31: first heat transfer plate; 32: second heat transfer plate; 200: receiving module; 210: receiving board; 211: receiver; 212: receiving substrate; 220: receiving shielding member; 221: first receiving shielding cover; 2211: first convex platform; 2212: second convex platform; 222: second receiving shielding cover; 2221: third convex platform; 230: signal amplification board; 241: first receiving driving circuit; 242: second receiving driving circuit; 243: third receiving driving circuit; 250: electrical connector; 300: housing; 310: first end plate; 320: second end plate; 330: peripheral side plate; 340: accommodating cavity; 350: window; 400: functional board; 410: bypass hole; 500: scanning module; 510: scanning component; 512: control board; 514: scanning heat transfer member; 5141: third heat transfer plate; 5142: fourth heat transfer plate; 600: window piece; x: first direction.

DETAILED DESCRIPTION

To further clarify the purpose, technical solutions, and advantages of the present application, embodiments thereof will be described in further detail below in conjunction with the accompanying drawings. Unless otherwise indicated, the same reference numerals in the different drawings represent the same or similar elements.

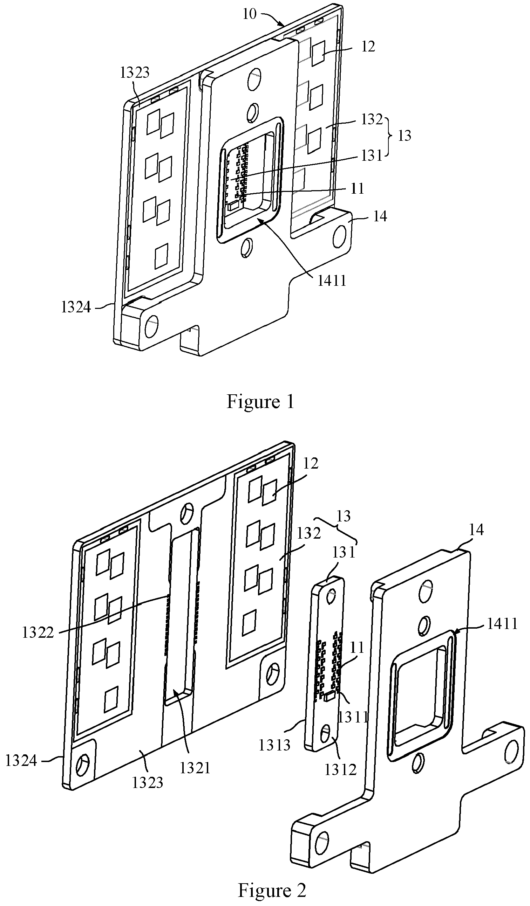

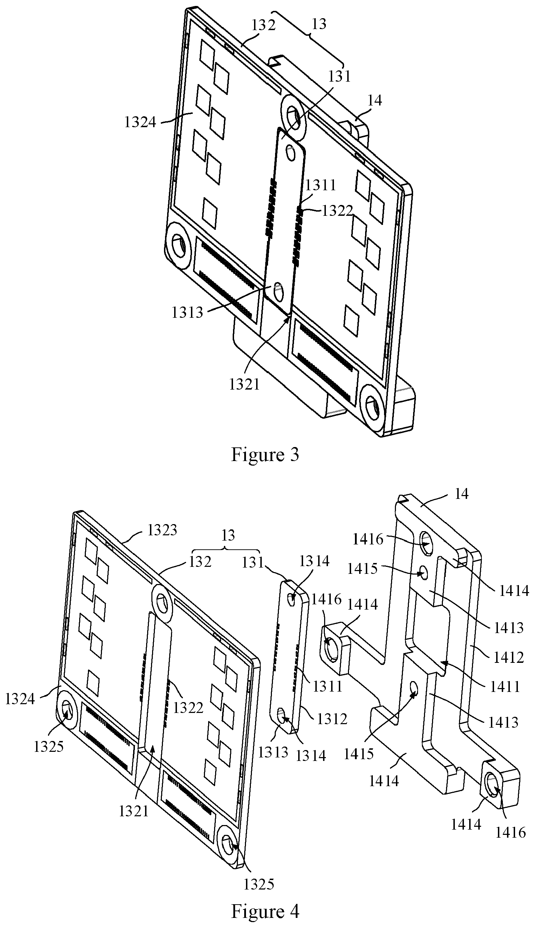

Referring to Figures 1 to 4, an embodiment provides an emitter 10, which includes a laser 11, a driving circuit 12, a substrate 13, and a heat conduction member 14. The driving circuit 12 is electrically connected to the laser 11 to drive the laser 11 to emit an optical signal for detecting a target object. The substrate 13 is used to carry the laser 11 and the driving circuit 12.

The heat conduction member 14 is connected to the substrate 13, and at least the portion of the substrate 13 used to mount the laser 11 is in contact with the heat conduction member 14. This is beneficial for timely and efficient heat dissipation from the laser 11 through the heat conduction member 14, improving the heat dissipation rate of the laser 11 and avoiding local hot spots at the laser 11, thus ensuring the normal operation of the laser 11.

The mounting carrier for the laser 11 and the driving circuit 12 can be the same carrier. For example, the substrate 13 includes a first substrate 131 and a second substrate 132, the laser 11 is mounted on the first substrate 131, and the driving circuit 12 is mounted on the second substrate 132.

The laser 11 and its driving circuit 12 being mounted on the same carrier, they dissipate heat together through the carrier, resulting in poor heat dissipation performance. For example, if the laser 11 and its driving circuit 12 are mounted on a PCB board, the low thermal conductivity of the PCB board, in the vertical direction, can cause local hot spots at the laser 11, hindering smooth heat conduction and limiting the power density of the laser 11, thus affecting the detection capability. If the laser 11 and driving circuit 12 are mounted on a ceramic board, the ceramic board is typically a double-layered board with traces on both sides, which is not suitable for circuit design of multi-channel laser 11 due to its limited number of trace layers. The process maturity, cost, and lead time of multi-layer ceramic boards cannot meet the requirements for mass production. Therefore, the laser 11 and the driving circuit 12 can be designed to be arranged on different mounting carriers.

The substrate 13 includes a first substrate 131 and a second substrate 132. The laser 11 is mounted on the first substrate 131, and the driving circuit 12 is mounted on the second substrate 132. The thermal conductivity of the second substrate 132 is lower than that of the first substrate 131. With higher thermal conductivity, the heat transfer speed from high-temperature areas to low-temperature areas is faster. Since the laser 11 has a higher power consumption and generates more heat during operation compared to the driving circuit 12, mounting the laser 11 on the first substrate 131 with higher thermal conductivity facilitates timely and efficient heat dissipation from the laser 11, improving the heat dissipation rate and avoiding local hot spots at the laser 11, thus ensuring its normal operation. The driving circuit 12 has relatively lower power consumption and generates less heat during operation, so mounting it on the second substrate 132 with lower thermal conductivity allows for a wider range of material choices and reduces manufacturing costs.

Arranging the entire driving circuit 12 on the second substrate 132 simplifies the design complexity of the first substrate 131 compared to having part of the driving circuit 12 on the first substrate 131 and the rest on the second substrate 132.

The first substrate 131 is provided with a first electrical connection pad 1311 electrically connected to the laser 11, and the second substrate 132 is provided with a second electrical connection pad 1322 electrically connected to the driving circuit 12. The first electrical connection pad 1311 is electrically connected to the second electrical connection pad 1322 via an electrical connector. During the manufacturing process, to achieve electrical connection between the laser 11 on the first substrate 131 and the driving circuit 12 on the second substrate 132, to reserve the first electrical connection pad 1311 on the first substrate 131 and the second electrical connection pad 1322 on the second substrate 132. The electrical connection between the laser 11 and the driving circuit 12 is converted into an electrical connection between the first electrical connection pad 1311 and the second electrical connection pad 1322, which can be easily achieved through an electrical connector, facilitating the electrical connection operation between the laser 11 and the driving circuit 12.

The first electrical connection pad 1311 and the second electrical connection pad 1322 can be soldering pads, and the electrical connector can be a metal wire, such as gold wire, copper wire, etc.

The emitter 10 can include at least one laser 11. For example, it can include one or multiple lasers 11. When multiple lasers 11 are included, they can be arranged in an array at intervals to detect target objects in different areas. In this case, each laser 11 is electrically connected to the driving circuit 12. The first substrate 131 can be provided with multiple first electrical connection pads 1311, each corresponding and electrically connected to one laser 11. The second substrate 132 can be provided with multiple second electrical connection pads 1322, all electrically connected to the driving circuit 12. The multiple first electrical connection pads 1311 can be correspondingly electrically connected to the multiple second electrical connection pads 1322 via an electrical connector.

The second substrate 132 is formed with a mounting opening 1321, and the first substrate 131 is located in the mounting opening 1321, making the structure of the substrate 13 more compact and helping to reduce the size of the emitter 10. The first electrical connection pad 1311 and the second electrical connection pad 1322 can both be arranged close to the inner wall surface of the mounting opening 1321 to reduce the distance between them and facilitate the electrical connection operation.

The first substrate 131 and the second substrate 132 can be in contact and connected with the heat conduction member 14. The heat conduction member 14 can serve as a carrier for the first substrate 131 and the second substrate 132, and it facilitates heat dissipation from the first substrate 131 and the second substrate 132. The heat conduction member 14 can be made of a material with high thermal conductivity to enhance the heat dissipation rate of the first substrate 131 and the second substrate 132.

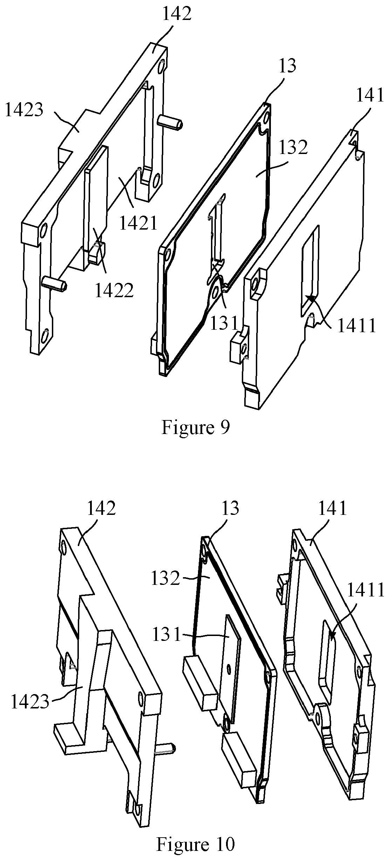

In an embodiment, referring to Figures 1 to 6, the heat conduction member 14 can be located on the side of the substrate 13 where the laser 11 is arranged. In this case, the heat conduction member 14 can be made of a tungsten-copper alloy. Referring to Figures 9 to 11, the heat conduction member 14 can include a first heat conduction plate 141 located on the side of the substrate 13 where the laser 11 is arranged and a second heat conduction plate 142 located on the side of the substrate 13 away from the laser 11. In this case, the first heat conduction plate 141 and the second heat conduction plate 142 can be made of the same material or different materials with different thermal conductivities.

Referring to Figures 1 to 6, when the heat conduction member 14 is located on the side of the substrate 13 where the laser 11 is arranged, the heat conduction member 14 avoids the laser 11, such as by providing a light emitting port 1411 corresponding to the laser 11, to allow the optical signal emitted by the laser 11 to pass through the light emitting port 1411 of the heat conduction member 14 for detecting the target object.

The first substrate 131 has a relative first plate surface 1312 and a second plate surface 1313, and the laser 11 is mounted on the first plate surface 1312. The second substrate 132 has a relative third plate surface 1323 and a fourth plate surface 1324, and the driving circuit 12 is mounted on at least one of the third plate surface 1323 and the fourth plate surface 1324. The mounting opening 1321 penetrates through the third plate surface 1323 and the fourth plate surface 1324. The third plate surface 1323 and the first plate surface 1312 are on the same side of the substrate 13, and the fourth plate surface 1324 and the second plate surface 1313 are on the same side of the substrate 13. The heat conduction member 14 is located on the side of the substrate 13 where the first plate surface 1312 is located.

The first substrate 131 and the second substrate 132 are thin plates, and among their multiple surfaces, the side surfaces are relatively narrow. Therefore, the plate surfaces of the first substrate 131 and the second substrate 132 can be considered as the remaining surfaces excluding the side surfaces. In this way, the first substrate 131 and the second substrate 132 can be regarded as having two relatively arranged plate surfaces, which can be parallel.

The first plate surface 1312 of the first substrate 131 and the third plate surface 1323 of the second substrate 132 can be coplanar or non-coplanar. The second plate surface 1313 of the first substrate 131 and the fourth plate surface 1324 of the second substrate 132 can be coplanar or non-coplanar. The first electrical connection pad 1311 can be arranged on at least one of the first plate surface 1312 and the second plate surface 1313, and the second electrical connection pad 1322 can be arranged on at least one of the third plate surface 1323 and the fourth plate surface 1324.

The thermal expansion coefficient of the heat conduction member 14 is $a$, and the thermal expansion coefficient of the first substrate 131 is b. The emitter 10 can satisfy the following condition: 3 ppm/°C $\leq$ |$a$ - $b$| $\leq$ 4 ppm/°C. By designing the difference between the thermal expansion coefficient of the heat conduction member 14 and the thermal expansion coefficient of the first substrate 131, their thermal expansion coefficients are made relatively close. In this way, the deformation of the heat conduction member 14 and the first substrate 131 after long-term use is similar, ensuring the reliability of the connection between them and making the connection parts less likely to separate.

The thermal expansion coefficient $a$ of the heat conduction member 14 can satisfy: 2 ppm/°C $\leq$ $a$ $\leq$ 6 ppm/°C. The thermal expansion coefficient $a$ of the heat conduction member 14 can be 2 ppm/°C, 3 ppm/°C, 4 ppm/°C, 5 ppm/°C, 6 ppm/°C, etc. The thermal expansion coefficient b of the first substrate 131 can satisfy: 6 ppm/°C $\leq$ b $\leq$ 10 ppm/°C. The thermal expansion coefficient b of the first substrate 131 can be 6 ppm/°C, 7 ppm/°C, 8 ppm/°C, 9 ppm/°C, 10 ppm/°C, etc.

In an embodiment, the preparation material of the first substrate 131 includes at least one of aluminum nitride, silicon carbide, and copper, and the preparation material of the heat conduction member 14 includes a tungsten-copper alloy. The first substrate 131 and the heat conduction member 14 have high thermal conductivity while maintaining relatively close thermal expansion coefficients for reliable connection.

As the thermal expansion coefficient of the heat conduction member 14 is close to that of the first substrate 131, they can be bonded using silver paste. Silver paste can be very thin with high thermal conductivity, resulting in a low thermal resistance at the contact interface between the heat conduction member 14 and the first substrate 131. The connection method between the heat conduction member 14 and the first substrate 131 can also be replaced with solder bonding (such as gold-tin bonding, etc.).

The preparation material of the second substrate 132 can include a material which has a difference in thermal expansion coefficients between the second substrate 132 and the heat conduction member 14, and they can be bonded using a low-modulus organic silicone soft adhesive (such as epoxy adhesive).

Referring to Figures 1 to 6, the first substrate 131 and the second substrate 132 can be connected to the heat conduction member 14. The first substrate 131 can be bonded to the heat conduction member 14 using silver paste, and the second substrate 132 can be bonded to the heat conduction member 14 using organic silicone soft adhesive.

The heat conduction member 14 includes a first main board 1412 and at least one first convex portion 1413 and at least one second convex portion 1414 connected to the first main board 1412. The first main board 1412 is located on the side of the substrate 13 where the laser 11 is arranged, and the first main board 1412 is provided with a light emitting port 1411. The first convex portion 1413 is arranged between the first main board 1412 and the substrate 13 and corresponds to the first substrate 131. The side of the first convex portion 1413 away from the first main board 1412 is in contact and connected with the first substrate 131, such as by contact and connection through silver paste. The second convex portion 1414 is arranged between the first main board 1412 and the substrate 13 and corresponds to the second substrate 132. The side of the second convex portion 1414 away from the first main board 1412 is in contact and connected with the second substrate 132, such as by contact and connection through organic silicone soft adhesive.

The first convex portion 1413 corresponds to the first substrate 131, the first convex portion 1413 is provided with an adhesive such as silver paste, which facilitates the determination of the adhesive application area and improves the efficiency of connection between the heat conduction member 14 and the first substrate 131 through the adhesive. The second convex portion 1414 corresponds to the second substrate 132, the second convex portion 1414 is provided with an adhesive such as silver paste, which facilitates the determination of the adhesive application area and improves the efficiency of connection between the heat conduction member 14 and the second substrate 132 through the adhesive.

The heat conduction member 14 can include multiple first convex portions 1413 and multiple second convex portions 1414 arranged at intervals. Each first convex portion 1413 and each second convex portion 1414 can be arranged at intervals, and at least one first convex portion 1413 can be integrally formed with at least one second convex portion 1414.

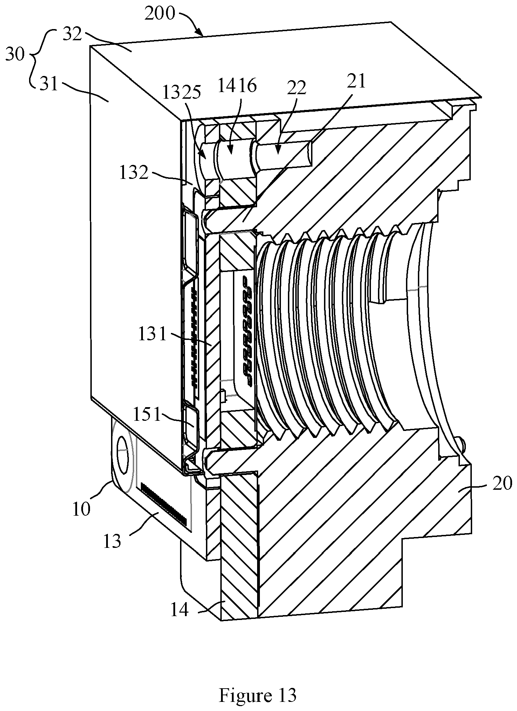

The heat conduction member 14 is provided with a first mounting hole 1415 at the portion corresponding to the first convex portion 1413. The first substrate 131 is provided with a second mounting hole 1314 corresponding to the first mounting hole 1415. The heat conduction member 14 and the first substrate 131 is connected via a first structural member 21 (refer to Figure 13) passing through the first mounting hole 1415 and the second mounting hole 1314. The arrangement of the first structural member 21 facilitates the assembly and positioning of the heat conduction member 14 and the first substrate 131. The connection between the heat conduction member 14 and the first substrate 131 at the first convex portion 1413 enhances the connection tightness between the first convex portion 1413 and the first substrate 131, improving the heat transfer performance between them. The first structural member 21 can be a positioning post, a screw, etc.

The heat conduction member 14 can be provided with a third mounting hole 1416 at the portion corresponding to the second convex portion 1414. The second substrate 132 can be provided with a fourth mounting hole 1325 corresponding to the third mounting hole 1416. The heat conduction member 14 and the second substrate 132 can also be connected via a second structural member passing through the third mounting hole 1416 and the fourth mounting hole 1325. The arrangement of the second structural member facilitates the assembly and positioning of the heat conduction member 14 and the second substrate 132. The connection between the heat conduction member 14 and the second substrate 132 at the second convex portion 1414 enhances the connection tightness between the second convex portion 1414 and the second substrate 132, improving the heat transfer performance between them. The second structural member can be a positioning post, a screw, etc.

The first substrate 131 and the heat conduction member 14 can be integrally formed. In an embodiment, the first electrical connection pad 1311 of the first substrate 131 and the second electrical connection pad 1322 of the second substrate 132 can be arranged corresponding to the light emitting port 1411 on the heat conduction member 14 to facilitate the electrical connection operation between the first electrical connection pad 1311 and the second electrical connection pad 1322.

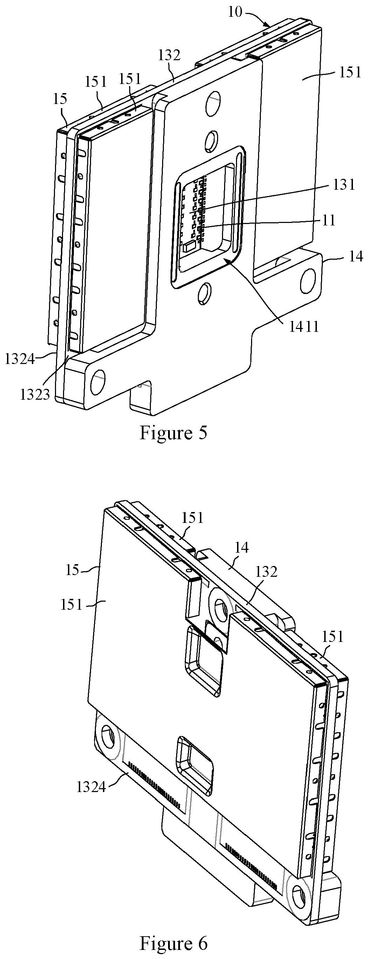

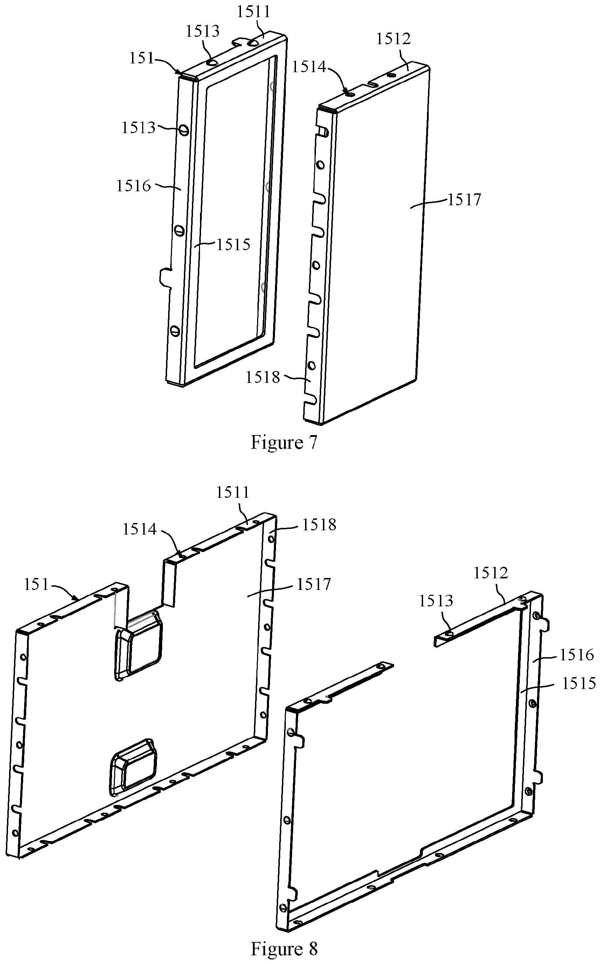

Referring to Figures 5 to 8, the emitter 10 further includes a shielding member 15. The shielding member 15 is used to cover the driving circuit 12 on the second substrate 132 and can shield the emitter 10 from the influence of external electromagnetic radiation, while also preventing interference generated during operation of the emitter 10 from propagating outward. The shielding member 15 is made of a metallic material.

Part of the driving circuit 12 is arranged on the third plate surface 1323 of the second substrate 132, and the remaining part is arranged on the fourth plate surface 1324 of the second substrate 132. The shielding member 15 includes two shielding covers 151, which are located on the side of the third plate surface 1323 and the side of the fourth plate surface 1324 of the second substrate 132, respectively. One of the two shielding covers 151, located on the side of the third plate surface 1323, avoids the laser 11.

One of the two shielding covers 151, located on the side of the third plate surface 1323, can form a bypass hole at the laser 11; or one of the two shielding covers 151, located on the side of the third plate surface 1323, can include two sub-shielding covers located on opposite sides of the laser 11.

The shielding cover 151 includes a connecting portion 1511 and a shielding portion 1512. The connecting portion 1511 is connected to the second substrate 132 and is provided with either a snapping member 1513 or a fastening member 1514. The shielding portion 1512 is provided with the other of the snapping member 1513 and the fastening member 1514, and the snapping member 1513 and the fastening member 1514 are detachably connected. The snap-fit detachable connection between the connecting portion 1511 and the shielding portion 1512 is convenient for assembly and disassembly.

The connecting portion 1511 can include a first connecting plate 1515 and a second connecting plate 1516. The middle portion of the first connecting plate 1515 is hollowed out, and the first connecting plate 1515 is spaced apart from the second substrate 132. One end of the second connecting plate 1516 is connected to the first connecting plate 1515, and the other end of the second connecting plate 1516 is bent relative to the first connecting plate 1515 and extends towards the second substrate 132 for connection with the second substrate 132. The second connecting plate 1516 is provided with either a snapping member 1513 or a fastening member 1514. The second connecting plate 1516 can be arranged corresponding to the edge of the first connecting plate 1515. When there are multiple second connecting plates 1516, different second connecting plates 1516 can be arranged corresponding to different edges of the first connecting plate 1515.

The connection between the connecting portion 1511 and the second substrate 132 can be a snap-fit connection. For example, the first connecting plate 1515 can be provided with either a snap block or a snap slot, and the second substrate 132 is provided with the other of the snap block and the snap slot, allowing for detachable connection.

The shielding portion 1512 can include a first shielding plate 1517 and a second shielding plate 1518. The first shielding plate 1517 is located on the side of the connecting portion 1511 away from the second substrate 132 and covers the connecting portion 1511. One end of the second shielding plate 1518 is connected to the first shielding plate 1517, and the other end of the second shielding plate 1518 is bent relative to the first shielding plate 1517 and extends towards the second substrate 132. The second shielding plate 1518 is provided with the other of the snapping member 1513 and the fastening member 1514. The second shielding plate 1518 can be generally arranged around the periphery of the first shielding plate 1517 to enhance the electromagnetic shielding performance of the emitter 10.

When one of the two shielding covers 151, located on the side of the third plate surface 1323, includes two sub-shielding covers, the two sub-shielding covers can also adopt the above-mentioned scheme including a connecting portion 1511 and a shielding portion 1512.

At least a portion of the first shielding plate 1517 of the shielding cover 151 located on the side of the fourth plate surface 1324 can be recessed towards the fourth plate surface 1324 to contact the fourth plate surface 1324. This increases the contact area between the second substrate 132 and the shielding cover 151 on the side of the fourth plate surface 1324, facilitating heat transfer from the fourth plate surface 1324 side to the shielding cover 151 on the fourth plate surface 1324 side, and improving the heat dissipation performance of the second substrate 132.

The recessed portion of the first shielding plate 1517 can correspond to the heat generating device on the second substrate 132, and the recessed portion and the heat generating device on the second substrate 132 can be in contact through thermal conductive gel to improve the heat transfer performance between them.

Referring to Figures 9 to 11, when the heat conduction member 14 includes a first heat conduction plate 141 located on the side of the substrate 13 where the laser 11 is arranged and a second heat conduction plate 142 located on the side of the substrate 13 away from the laser 11, the first heat conduction plate 141 and the second heat conduction plate 142 can cover the driving circuit 12 on the second substrate 132. Both the first heat conduction plate 141 and the second heat conduction plate 142 can be metal members. Since the first heat conduction plate 141 and the second heat conduction plate 142 are metal members, they can achieve heat transfer and electromagnetic shielding, eliminating the need for a separate shielding member on the emitter 10, simplifying the structure of the emitter 10, and reducing its manufacturing costs.

The first heat conduction plate 141 is located on the side of the substrate 13 where the laser 11 is arranged and avoids the laser 11, such as by providing a light emitting port 1411 corresponding to the laser 11 on the first heat conduction plate 141. The second heat conduction plate 142 is located on the side of the substrate 13 away from the laser 11. Part of the driving circuit 12 is located on the side of the second substrate 132 where the laser 11 is arranged and is covered by the first heat conduction plate 141. Another part of the driving circuit 12 is located on the side of the second substrate 132 away from the laser 11 and is covered by the second heat conduction plate 142.

The first heat conduction plate 141 can be in contact with both the second substrate 132 and the emitting lens 20, transferring the heat generated by the driving circuit 12 on the side of the second substrate 132 where the laser 11 is located to the emitting lens 20, and then dissipating it outward through the emitting lens 20. For example, the heat can be transferred from the emitting lens 20 to the first end plate 310 and the second end plate 320 of the housing 300, and/or directly from the first heat conduction plate 141 to the first end plate 310 and the second end plate 320, etc.

The second heat conduction plate 142 can be in contact with both the first substrate 131 and the second substrate 132, transferring the heat generated by the driving circuit 12 on the side of the second substrate 132 away from the laser 11 and the heat generated by the laser 11 on the first substrate 131 outward. For example, the second heat conduction plate 142 can directly contact the peripheral side plate 330 of the housing 300 to transfer heat to the peripheral side plate 330, and/or the second heat conduction plate 142 can transfer heat to the emitting lens 20 through a heat transfer member 30, and then dissipate it through the emitting lens 20 to the first end plate 310 and the second end plate 320, etc.

The second heat conduction plate 142 includes a second main board 1421 and a third convex portion 1422 mounted on the second main board 1421. The second main board 1421 is located on the side of the substrate 13 away from the laser 11 and covers the driving circuit 12 on that side. The third convex portion 1422 is arranged between the second main board 1421 and the substrate 13 and corresponds to the first substrate 131, contacting the first substrate 131, such as through contact and connection with silver paste. The second main board 1421 contacts the second substrate 132, such as through contact and connection with organic silicone soft adhesive (epoxy adhesive, etc.).

The second heat conduction plate 142 includes a fourth convex portion 1423 mounted on the second main board 1421. The fourth convex portion 1423 is arranged on the side of the second main board 1421 away from the substrate 13 and contacts the peripheral side plate 330 of the housing 300, such as through contact and connection with thermal conductive gel or contact through a thermal pad. The fourth convex portion 1423 correspond to the first substrate 131.

The thermal expansion coefficient of the second heat conduction plate 142 is c, and the thermal expansion coefficient of the first substrate 131 is b. The emitter 10 can satisfy the following condition: 3 ppm/°C $\leq$ |c - *b*| $\leq$ 4 ppm/°C. By reasonably designing the difference between the thermal expansion coefficient of the second heat conduction plate 142 and the thermal expansion coefficient of the first substrate 131, their thermal expansion coefficients are made relatively close. In this way, the deformation of the second heat conduction plate 142 and the first substrate 131 after long-term use is roughly similar, ensuring the reliability of the connection between them and making the connection parts less likely to separate.

The thermal expansion coefficient c of the second heat conduction plate 142 can satisfy: 2 ppm/°C $\leq$ *c* $\leq$ 6 ppm/°C. The thermal expansion coefficient c of the second heat conduction plate 142 can be 2 ppm/°C, 3 ppm/°C, 4 ppm/°C, 5 ppm/°C, 6 ppm/°C, etc. The thermal expansion coefficient *b* of the first substrate 131 can satisfy: 6 ppm/°C $\leq$ *b* $\leq$ 10 ppm/°C. The thermal expansion coefficient b of the first substrate 131 can be 6 ppm/°C, 7 ppm/°C, 8 ppm/°C, 9 ppm/°C, 10 ppm/°C, etc.

In an embodiment, the preparation material of the first substrate 131 includes at least one of aluminum nitride, silicon carbide, and copper, and the preparation material of the second heat conduction plate 142 includes a tungsten-copper alloy. This ensures that the first substrate 131 and the second heat conduction plate 142 have high thermal conductivity while maintaining relatively close thermal expansion coefficients for reliable connection.

As the thermal expansion coefficient of the second heat conduction plate 142 is close to that of the first substrate 131, they can be bonded using silver paste. Silver paste can be very thin with high thermal conductivity, resulting in a low thermal resistance at the contact interface between the second heat conduction plate 142 and the first substrate 131. The connection method between the second heat conduction plate 142 and the first substrate 131 can also be replaced with solder bonding (such as gold-tin bonding, etc.).

The preparation material of the second substrate 132 can include a material. In an embodiment, there is a significant difference in thermal expansion coefficients between the second substrate 132 and the second heat conduction plate 142, and they can be bonded using a low-modulus organic silicone soft adhesive (such as epoxy adhesive).

The thermal conductivity of the first heat conduction plate 141 can be lower than that of the second heat conduction plate 142. Since the first heat conduction plate 141 is used to transfer the heat generated by the driving circuit 12 on the side of the second substrate 132 where the laser 11 is located, the heat is relatively low. The second heat conduction plate 142 is used to transfer the heat generated by the driving circuit 12 on the side of the second substrate 132 away from the laser 11 and the heat generated by the laser 11 on the first substrate 131, and the heat is relatively high. Therefore, setting the thermal conductivity of the first heat conduction plate 141 lower than that of the second heat conduction plate 142 facilitates timely and efficient outward transfer of heat from high-temperature areas, while maintaining a relatively normal transfer speed for heat in low-temperature areas, thereby reducing the manufacturing cost of the LiDAR 1 while ensuring a high heat dissipation rate.

The first heat conduction plate 141 can be made of a metal heat conduction member such as aluminum, and the second heat conduction plate 142 can be made of a metal heat conduction member such as a tungsten-copper alloy.

In an embodiment, when there is a gap between the first heat conduction plate 141 and the second heat conduction plate 142 and the substrate 13, thermal conductive gel can be filled between the heat conduction plate and the substrate 13. The thermal conductive gel can transfer the heat on the substrate 13 to the first heat conduction plate 141 and the second heat conduction plate 142, thus reducing the requirement for the thermal conductivity of the first heat conduction plate 141 and the second heat conduction plate 142.

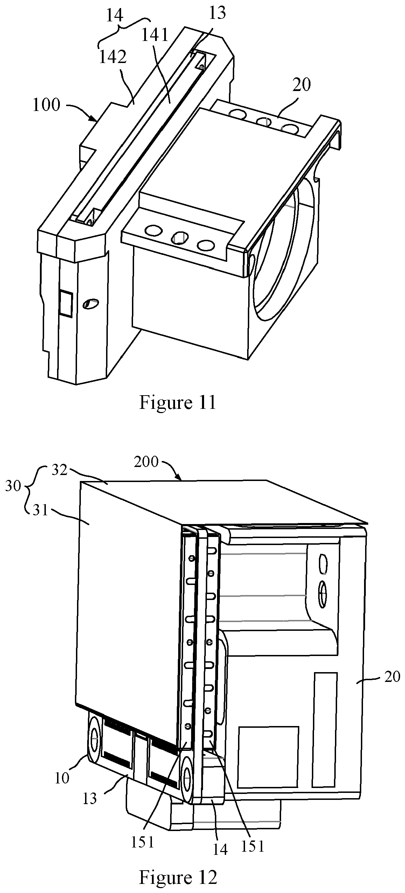

Referring to Figures 11 to 12, an embodiment provides an emitting module 200. The emitting module 200 includes the aforementioned emitter 10 and an emitting lens 20. The emitting lens 20 is located on the light emitting side of the laser 11 of the emitter 10. The emitting lens 20 can be used to shape, collimate, or otherwise process the optical signal emitted by the laser 11.

The heat conduction member 14 is in contact and connected with the emitting lens 20, so that the heat from the emitter 10 can be transferred to the emitting lens 20. The heat conduction member 14 and the emitting lens 20 can be in contact and connected through thermal conductive gel. The emitting lens 20 includes an emitting lens barrel and an emitting lens element mounted within the emitting lens barrel. The emitting lens barrel can be in contact with the emitter 10 and can be made of a metal member to improve the thermal conductivity of the emitting lens 20.

Referring to Figure 13, the first structural member 21 passing through the first mounting hole 1415 and the second mounting hole 1314 can be mounted on the emitting lens 20, or the emitting lens 20 can be provided with a fifth mounting hole corresponding to the first mounting hole 1415 and the second mounting hole 1314, and the first structural member 21 passes through the fifth mounting hole to facilitate positioning and assembly between the emitter 10 and the emitting lens 20. A quantity of second mounting holes 1314 on the heat conduction member 14 can be multiple, and the multiple second mounting holes 1314 are distributed on the top and bottom of the heat conduction member 14.

The second structural member passing through the third mounting hole 1416 and the fourth mounting hole 1325 can be mounted on the emitting lens 20, or the emitting lens 20 can be provided with a sixth mounting hole 22 corresponding to the third mounting hole 1416 and the fourth mounting hole 1325, and the second structural member also passes through the sixth mounting hole 22 to facilitate positioning and assembly between the emitter 10 and the emitting lens 20. A quantity of fourth mounting holes 1325 on the heat conduction member 14 can be multiple, and the multiple fourth mounting holes 1325 are distributed on the top and bottom of the heat conduction member 14.

In an embodiment, the second structural member is a screw, and the emitting lens 20 is provided with the sixth mounting hole 22. The sixth mounting hole 22 is a threaded hole that matches the screw, allowing for connection between the emitter 10 and the emitting lens 20 through the screw, and increasing the contact tightness between the emitter 10 and the emitting lens barrel near the screw, improving the heat transfer efficiency between them.

The emitting module 200 includes a heat transfer member 30. The heat transfer member 30 includes a first heat transfer plate 31 and a second heat transfer plate 32. The first heat transfer plate 31 is located on the side of the emitter 10 away from the emitting lens 20 and contacts the emitter 10. One end of the second heat transfer plate 32 is connected to the first heat transfer plate 31, and the other end of the second heat transfer plate 32 extends towards the emitting lens 20. The second heat transfer plate 32 is in contact with both the first heat transfer plate 31 and the emitting lens 20 (such as the emitting lens barrel). In this way, the heat from the side of the emitter 10 away from the emitting lens 20 can be transferred to the emitting lens 20 through the first heat transfer plate 31 and the second heat transfer plate 32, and then dissipated outward from the emitting lens 20. The arrangement of the heat transfer member 30 is beneficial for increasing the heat conduction area and improving the heat conduction performance.

The preparation material of the heat transfer member 30 can be graphene, etc. The contact between the second heat transfer plate 32 and the emitting lens 20, and between the first heat transfer plate 31 and the emitter 10, can be achieved through thermal conductive gel for heat dissipation.

In an embodiment, the heat transfer member 30 can also be omitted, and heat dissipation can be achieved by direct contact between the emitter 10 and the housing 300 of the LiDAR 100.

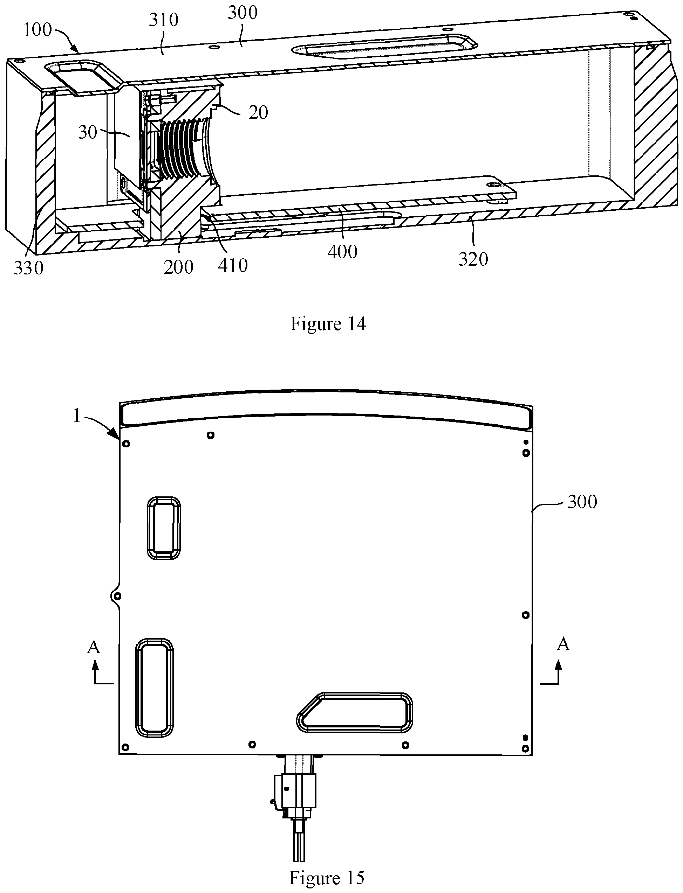

Referring to Figure 14, an embodiment provides a LiDAR 100. The LiDAR 100 includes the emitting module 200 and a housing 300, with the emitting module 200 mounted within the housing 300.

The emitting lens 20 in the emitting module 200 is in contact with the housing 300 to facilitate outward dissipation of the heat transferred from the emitter 10 to the emitting lens 20 through the housing 300. The top and bottom of the emitting lens 20 can be in contact with the housing 300, allowing the heat transferred from the emitter 10 to be dissipated through different parts of the housing 300. For example, the heat from the top of the heat conduction member 14 can be transferred to the top of the emitting lens 20 and then dissipated through the first end plate 310 at the top of the housing 300. The heat from the bottom of the heat conduction member 14 can be transferred to the bottom of the emitting lens 20 and then dissipated through the second end plate 320 at the bottom of the housing 300. The emitting module 200 and the first end plate 310 and the second end plate 320 can be in contact through a thermal pad, so that the heat on the emitting module 200 can be timely transferred to the first end plate 310 and the second end plate 320 through the thermal pad.

The top and bottom of the heat conduction member 14 can directly contact the first end plate 310 and the second end plate 320 of the housing 300, facilitating direct heat dissipation from the housing 300, reducing the heat transfer path, and lowering the thermal resistance.

When a functional board 400 is arranged at the bottom of the heat conduction member 14 and/or the bottom of the emitting lens 20, and the bottom of the heat conduction member 14 and/or the bottom of the emitting lens 20 is in contact with the housing 300, a bypass hole 410 is provided on the functional board 400 to allow direct contact between the bottom of the heat conduction member 14 and/or the bottom of the emitting lens 20 and the housing 300. For example, when a digital board is arranged at the bottom of the heat conduction member 14 and/or the bottom of the emitting lens 20, a bypass hole 410 can be provided on the digital board.

Referring to Figures 15 to 18, an embodiment provides a LiDAR 1. The LiDAR 1 includes an emitting module 100, a receiving module 200, a housing 300, and a scanning module 500. The housing 300 forms an accommodating cavity 340, and the emitting module 100, the receiving module 200, and the scanning module 500 are located within the accommodating cavity 340 of the housing 300. The emitting module 100 is used to output detection light, and the scanning module 500 is used to receive the detection light and transmit it to a target object. The scanning module 500 is used to receive the echo light reflected from the target object by the detection light and transmit the echo light to the receiving module 200. The arrangement of the scanning module 500 can increase the transmission field of view angle and the receiving field of view angle of the LiDAR 1, thereby expanding the detection range of the LiDAR 1.

The emitting module 100, the receiving module 200, and the scanning module 500 are all thermally connected to the housing 300, enabling the timely dissipation of heat generated by the emitting module 100, the receiving module 200, and the scanning module 500 during operation through the housing 300, ensuring the safe and stable operation of the LiDAR 1. The emitting module 100, the receiving module 200, and the scanning module 500 are thermally connected to different parts of the housing 300, allowing the heat generated by the emitting module 100, the receiving module 200, and the scanning module 500 to be dissipated outward through different parts of the housing 300, avoiding local heat concentration on the housing 300 that could affect the heat dissipation rate.

The implementation of thermal connection between two components in an embodiment can be achieved by connecting the two components through a thermal conduction structural member. The thermal conduction structural member can be reused with one of the two components, or it can be independent of the two components. For example, the thermal conduction structural member can be a thermal pad, a thermal adhesive layer, etc.

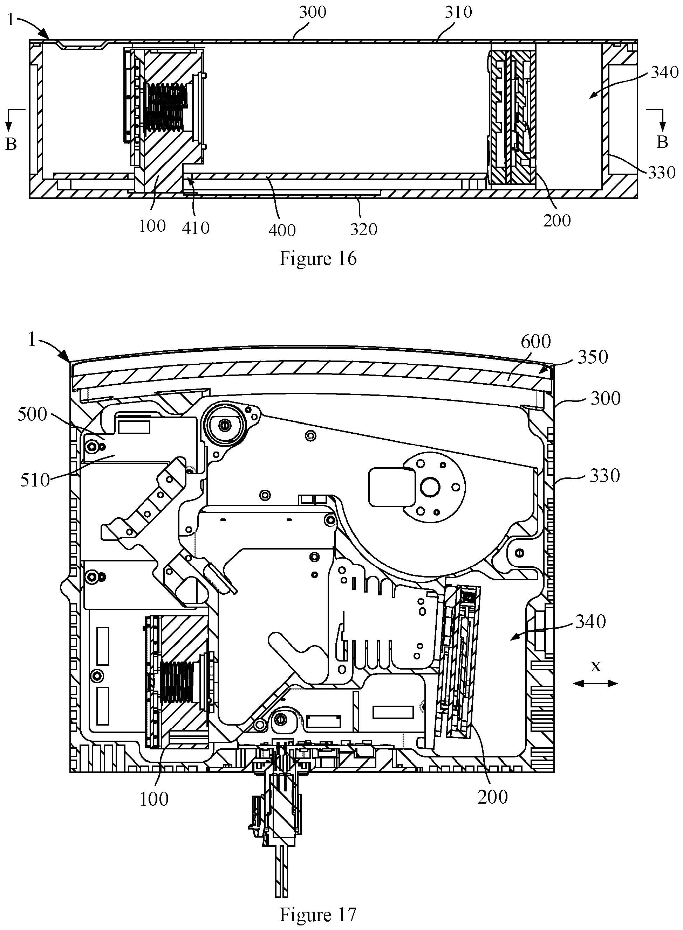

Referring to Figure 17, the housing 300 is provided with a window 350 that communicates with the accommodating cavity 340. The LiDAR 1 further includes a window piece 600 that covers the window 350 and is connected to the housing 300. Along the transmission direction of the detection light, the window piece 600 is located downstream of the scanning module 500. Along the transmission direction of the echo light, the window piece 600 is located upstream of the scanning module 500. The scanning module 500 is arranged closer to the window piece 600 than the emitting module 100, and the scanning module 500 is also arranged closer to the window piece 600 than the receiving module 200. The emitting module 100 and the receiving module 200 are spaced apart. The different thermal connection locations between the emitting module 100, the receiving module 200, and the scanning module 500 and the housing 300 are achieved through the layout of the emitting module 100, the receiving module 200, and the scanning module 500 within the housing 300. For example, the scanning module 500 is thermally connected to the part of the housing 300 near the window piece 600, while the emitting module 100 and the receiving module 200 are thermally connected to different parts of the housing 300 away from the window piece 600.

The spacing between the emitting module 100 and the receiving module 200 can be: the emitting module 100 and the receiving module 200 are spaced apart in a first direction x, where the first direction x is parallel to the window piece 600. This allows the emitting module 100 to be thermally connected to one side of the housing 300 away from the window piece 600 (such as the lower left side in Figure 17), and the receiving module 200 to be thermally connected to the other side of the housing 300 away from the window piece 600 (such as the lower right side in Figure 17). This maximizes the distance between the emitting module 100 and the receiving module 200, improving the heat dissipation rate of the housing 300.

Referring to Figures 16 to 18, the housing 300 includes a first end plate 310, a second end plate 320 opposite to and spaced apart from the first end plate 310, and a peripheral side plate 330 connected between the first end plate 310 and the second end plate 320. The first end plate 310, the second end plate 320, and the peripheral side plate 330 enclose and form the accommodating cavity 340. The first end plate 310 can be thermally connected to at least one of the emitting module 100, the receiving module 200, and the scanning module 500. The second end plate 320 can be thermally connected to at least one of the emitting module 100, the receiving module 200, and the scanning module 500. The peripheral side plate 330 can be thermally connected to at least one of the emitting module 100, the receiving module 200, and the scanning module 500. This allows the heat from the emitting module 100, the receiving module 200, and the scanning module 500 to be dispersed to more plates of the housing 300, making the heat distribution on the housing 300 relatively uniform and conducive to improving the heat dissipation rate. The window 350 can be formed on the peripheral side plate 330.

In an embodiment, the emitting module 100 is thermally connected to both the first end plate 310 and the second end plate 320. The receiving module 200 is thermally connected to both the first end plate 310 and the second end plate 320. The scanning module 500 is thermally connected to both the first end plate 310 and the peripheral side plate 330. The first end plate 310 can correspond to the top plate of the LiDAR 100 during use, and the second end plate 320 can correspond to the bottom plate of the LiDAR 100 during use.

When the emitting module 100 is thermally connected to the second end plate 320 of the housing 300, and a functional board 400 is arranged on the side of the emitting module 100 close to the second end plate 320, a bypass hole 410 is provided on the functional board 400 to allow the emitting module 100 to directly thermally connect with the second end plate 320 through the bypass hole 410. For example, when the functional board 400 is a digital board, a bypass hole 410 can be provided on the digital board.

When the emitting module 100 is thermally connected to the first end plate 310 of the housing 300, and a device is arranged on the side of the emitting module 100 close to the first end plate 310, a bypass hole can also be provided on the device. When a device is arranged on the side of the receiving module 200 close to the second end plate 320 and/or a device is arranged on the side of the receiving module 200 close to the first end plate 310, bypass holes can be provided on the devices to allow the receiving module 200 to thermally connect with the second end plate 320 and/or the first end plate 310 through the bypass holes.

The heat generating device of the functional board 400 can be arranged on the side of the functional board 400 close to the second end plate 320 to reduce the distance between the heat generating device and the second end plate 320, thereby improving the heat dissipation rate. Furthermore, a functional shielding member can be arranged on the side of the functional board 400 close to the second end plate 320. One side of the functional shielding member can be thermally connected to the heat generating device, and the other side can be thermally connected to the second end plate 320, enabling the heat generated by the heat generating device to be timely transferred to the second end plate 320 through the functional shielding member and then dissipated outward from the second end plate 320. The thermal connection between the functional shielding member and the heat generating device and the second end plate 320 can be achieved through thermal conductive gel.

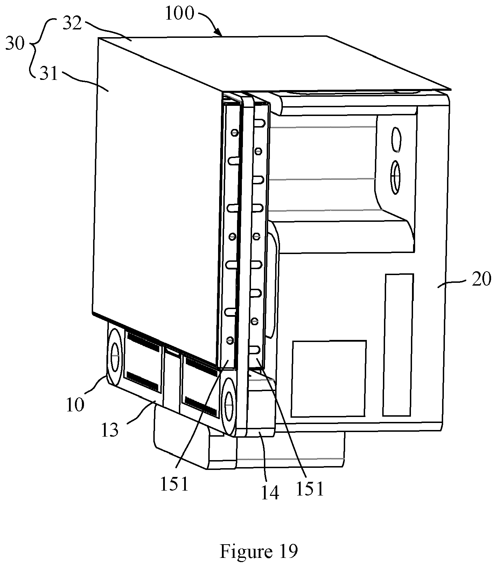

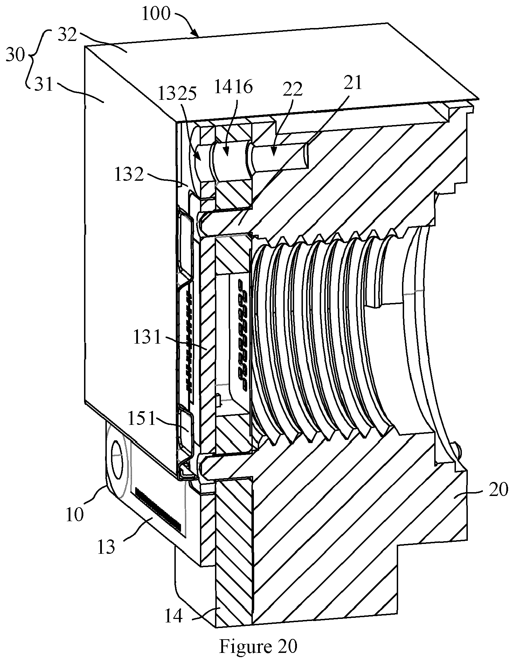

Referring to Figures 19 and 20, the emitting module 100 includes an emitter 10 and an emitting lens 20. The emitter 10 is used to output detection light, and the emitting lens 20 is used to receive the detection light and transmit it to the scanning module 500. The thermal connection between the emitting module 100 and the housing 300 can be achieved by the emitter 10 being thermally connected to the housing 300, or by the emitter 10 being thermally connected to the emitting lens 20 and the emitting lens 20 being thermally connected to the housing 300.

The emitting module 100 can include an emitting heat transfer member 30. The emitting heat transfer member 30 includes a first heat transfer plate 31 and a second heat transfer plate 32. The first heat transfer plate 31 is located on the side of the emitter 10 away from the emitting lens 20 and is thermally connected to the emitter 10, such as by being attached to the emitter 10. One end of the second heat transfer plate 32 is connected to the first heat transfer plate 31, and the other end of the second heat transfer plate 32 extends towards the emitting lens 20. The second heat transfer plate 32 is thermally connected to the emitting lens 20, such as by being attached to the emitting lens 20. In this way, the heat from the side of the emitter 10 away from the emitting lens 20 can be transferred to the emitting lens 20 through the first heat transfer plate 31 and the second heat transfer plate 32, and then dissipated outward from the emitting lens 20. The arrangement of the emitting heat transfer member 30 is beneficial for increasing the heat conduction area of the emitting module 100 and improving the heat conduction performance.

The preparation material of the emitting heat transfer member 30 can be graphene, etc. The thermal connection between the second heat transfer plate 32 and the emitting lens 20, and between the first heat transfer plate 31 and the emitter 10, can be achieved through thermal conductive gel.

In an embodiment, the emitter 10 and the emitting lens 20 are thermally connected to the second end plate 320. The second heat transfer plate 32 of the emitting heat transfer member 30 is located on the side of the emitter 10 and the emitting lens 20 close to the first end plate 310 and is thermally connected to the first end plate 310. This allows the heat from the bottom of the emitting module 100 to be transferred to the second end plate 320 through the emitter 10 and the emitting lens 20, and the heat from the top of the emitting module 100 to be transferred to the first end plate 310 through the second heat transfer plate 32 and the emitting lens 20.

The emitting lens 20 includes an emitting lens barrel and an emitting lens element mounted within the emitting lens barrel. The emitting lens barrel can be thermally connected to the emitter 10 and the emitting heat transfer member 30 and can be made of a metal member to improve the thermal conductivity of the emitting lens 20.

In an embodiment, the emitting heat transfer member 30 can also be omitted, and heat dissipation can be achieved by direct thermal connection between the emitter 10 and/or the emitting lens 20 and the first end plate 310 and the second end plate 320.

The thermal connection between the emitting module 100 and the first end plate 310 and the second end plate 320 can be achieved through a thermal pad, so that the heat on the emitting module 100 can be timely transferred to the first end plate 310 and the second end plate 320 through the thermal pad.

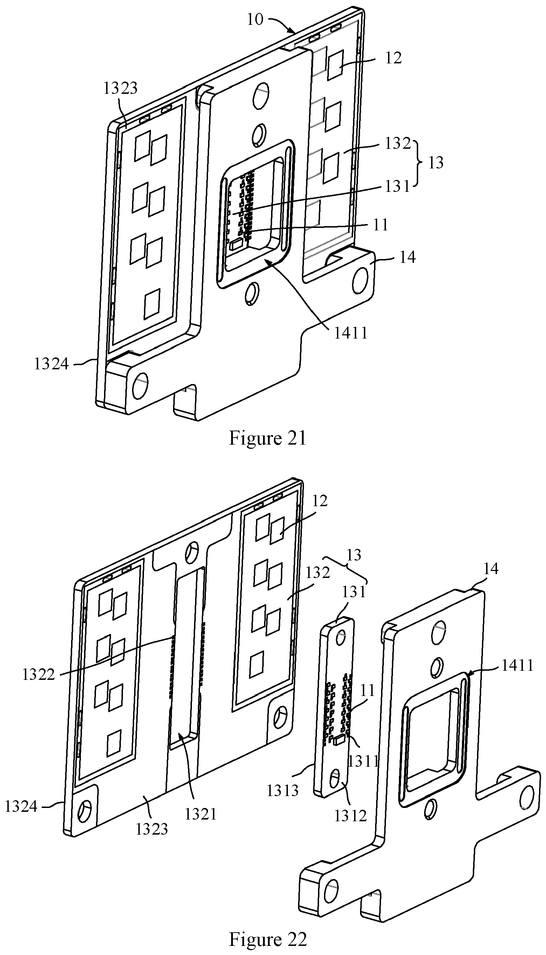

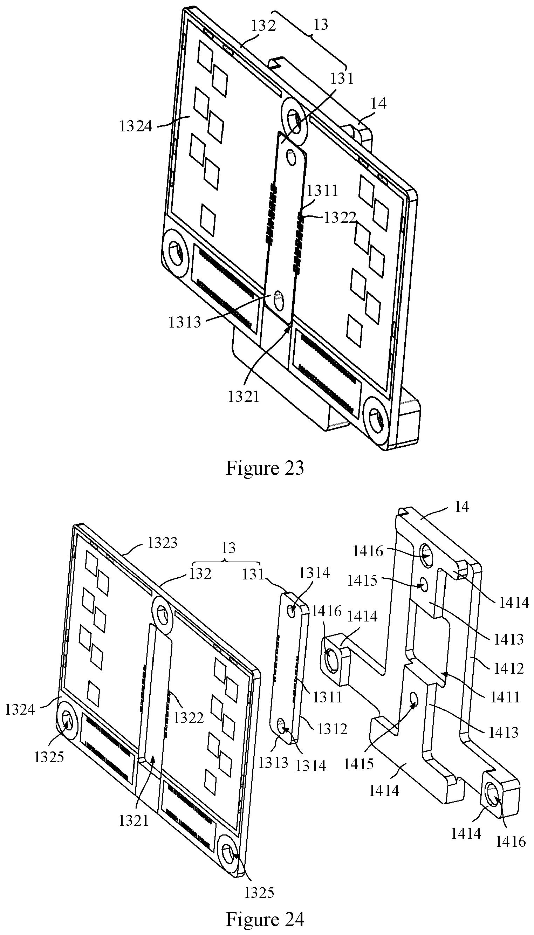

Referring to Figures 21 to 24, the emitter 10 includes a laser 11, an emitting driving circuit 12, an emitting substrate 13, and a heat conduction member 14. The laser 11 is electrically connected to the emitting driving circuit 12. The laser 11 and the emitting driving circuit 12 are mounted on the emitting substrate 13, and the heat conduction member 14 is thermally connected to the emitting substrate 13. The heat conduction member 14 can be made of a material with high thermal conductivity, such as a tungsten-copper alloy, etc., so that the heat on the emitting substrate 13 can be timely and efficiently transferred to the heat conduction member 14, and then transferred outward from the heat conduction member 14, improving the heat dissipation rate of the emitting module 100.

In an embodiment, the thermal connection between the emitter 10 and the housing 300 can be achieved by: the heat conduction member 14 being thermally connected to the housing 300. The thermal connection between the emitter 10 and the emitting lens 20 can be specifically achieved by: the heat conduction member 14 being thermally connected to the emitting lens 20.

The top and bottom of the emitting lens 20 can be thermally connected to the first end plate 310 and the second end plate 320 of the housing 300, respectively, so that the heat transferred from the emitter 10 can be dissipated through different parts of the housing 300. The heat from the top of the heat conduction member 14 can be transferred to the top of the emitting lens 20 and then dissipated through the first end plate 310 at the top of the housing 300. The heat from the bottom of the heat conduction member 14 can be transferred to the bottom of the emitting lens 20 and then dissipated through the second end plate 320 at the bottom of the housing 300.

The top and bottom of the heat conduction member 14 can be directly thermally connected to the first end plate 310 and the second end plate 320 of the housing 300, facilitating direct heat dissipation from the housing 300, reducing the heat transfer path, and lowering the thermal resistance.

When a functional board 400 is arranged at the bottom of the heat conduction member 14 and/or the bottom of the emitting lens 20, the bottom of the heat conduction member 14 and/or the bottom of the emitting lens 20 passes through the bypass hole 410 on the functional board 400 to thermally connect with the second end plate 320.

The mounting carrier for the laser 11 and the emitting driving circuit 12 can be the same carrier. For example, the substrate 13 includes a first substrate 131 and a second substrate 132. The laser 11 is mounted on the first substrate 131, and the emitting driving circuit 12 is mounted on the second substrate 132. The first substrate 131 and the second substrate 132 may not be differentiated.

As the laser 11 and its emitting driving circuit 12 being mounted on the same carrier, they dissipate heat together through the carrier, resulting in poor heat dissipation performance. For example, if the laser 11 and its emitting driving circuit 12 are mounted on a PCB board, the low thermal conductivity of the PCB board, especially in the vertical direction, can cause local hot spots at the laser 11, hindering smooth heat conduction and limiting the power density of the laser 11, thus affecting the detection capability. If the laser 11 and its emitting driving circuit 12 are mounted on a ceramic board, the ceramic board is typically a double-layered board with traces on both sides, which is not suitable for circuit design of multi-channel laser 11 due to its limited number of trace layers. Moreover, the process maturity, cost, and lead time of multi-layer ceramic boards cannot meet the requirements for mass production. Therefore, the laser 11 and the emitting driving circuit 12 can be designed to be arranged on different mounting carriers.

The emitting substrate 13 includes a first substrate 131 and a second substrate 132. The laser 11 is mounted on the first substrate 131, and the emitting driving circuit 12 is mounted on the second substrate 132. The thermal conductivity of the second substrate 132 is lower than that of the first substrate 131. With higher thermal conductivity, the heat transfer speed from high-temperature areas to low-temperature areas is faster. Since the laser 11 has a higher power consumption and generates more heat during operation compared to the emitting driving circuit 12, mounting the laser 11 on the first substrate 131 with higher thermal conductivity facilitates timely and efficient heat dissipation from the laser 11, improving the heat dissipation rate and avoiding local hot spots at the laser 11, thus ensuring its normal operation. The emitting driving circuit 12 has relatively lower power consumption and generates less heat during operation, so mounting it on the second substrate 132 with lower thermal conductivity allows for a wider range of material choices and reduces manufacturing costs.

Arranging the entire emitting driving circuit 12 on the second substrate 132 simplifies the design complexity of the first substrate 131, compared to having part of the emitting driving circuit on the first substrate and the rest on the second substrate.

The first substrate 131 is provided with a first electrical connection pad 1311 electrically connected to the laser 11, and the second substrate 132 is provided with a second electrical connection pad 1322 electrically connected to the emitting driving circuit 12. The first electrical connection pad 1311 is electrically connected to the second electrical connection pad 1322 via an electrical connector. During the manufacturing process, to achieve electrical connection between the laser 11 on the first substrate 131 and the emitting driving circuit 12 on the second substrate 132, it is to reserve the first electrical connection pad 1311 on the first substrate 131 and the second electrical connection pad 1322 on the second substrate 132. The electrical connection between the laser 11 and the emitting driving circuit 12 is then converted into an electrical connection between the first electrical connection pad 1311 and the second electrical connection pad 1322, which can be easily achieved through an electrical connector, facilitating the electrical connection operation between the laser 11 and the emitting driving circuit 12.

The first electrical connection pad 1311 and the second electrical connection pad 1322 can be soldering pads, and the electrical connector can be a metal wire, such as gold wire, copper wire, etc.

The emitter 10 can include at least one laser 11. For example, it can include one or multiple lasers 11. When multiple lasers 11 are included, they can be arranged in an array at intervals to detect target objects in different areas. In this case, each laser 11 is electrically connected to the emitting driving circuit 12. The first substrate 131 can be provided with multiple first electrical connection pads 1311, each corresponding and electrically connected to one laser 11. The second substrate 132 can be provided with multiple second electrical connection pads 1322, electrically connected to the emitting driving circuit 12. The multiple first electrical connection pads 1311 can be correspondingly electrically connected to the multiple second electrical connection pads 1322 via an electrical connector.

The second substrate 132 is formed with a mounting opening 1321, and the first substrate 131 is located in the mounting opening 1321, making the structure of the emitting substrate 13 more compact and helping to reduce the size of the emitter 10. The first electrical connection pad 1311 and the second electrical connection pad 1322 can both be arranged close to the inner wall surface of the mounting opening 1321, to reduce the distance between them and facilitate the electrical connection operation.

The first substrate 131 and the second substrate 132 are thermally connected to the heat conduction member 14. The heat conduction member 14 can serve as a carrier for the first substrate 131 and the second substrate 132, and it facilitates heat dissipation from the first substrate 131 and the second substrate 132. The heat conduction member 14 is made of a material with high thermal conductivity to enhance the heat dissipation rate of the first substrate 131 and the second substrate 132.

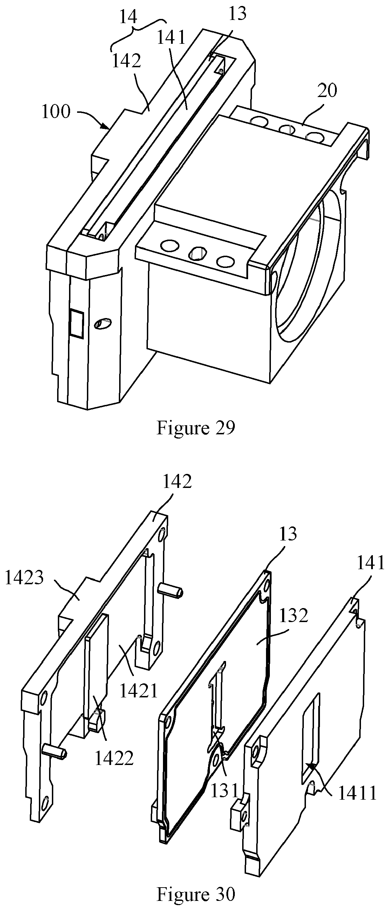

In an embodiment, referring to Figures 21 to 26, the heat conduction member 14 can be located between the emitting substrate 13 and the emitting lens 20. In an embodiment, the heat conduction member 14 can be made of a tungsten-copper alloy. Referring to Figures 29 to 31, the heat conduction member 14 includes a first heat conduction plate 141 located between the emitting substrate 13 and the emitting lens 20 and a second heat conduction plate 142 located on the side of the emitting substrate 13 away from the emitting lens 20. In an embodiment, the first heat conduction plate 141 and the second heat conduction plate 142 can be made of the same material or different materials with different thermal conductivities.

Referring to Figures 21 to 26, when the heat conduction member 14 is located on the side of the substrate 13 where the laser 11 is arranged, the heat conduction member 14 avoids the laser 11, such as by providing a light emitting port 1411 corresponding to the laser 11, to allow the detection light output by the laser 11 to reach the emitting lens 20 through the light emitting port 1411.

The first substrate 131 has a relative first plate surface 1312 and a second plate surface 1313, and the laser 11 is mounted on the first plate surface 1312. The second substrate 132 has a relative third plate surface 1323 and a fourth plate surface 1324, and the emitting driving circuit 12 is mounted on at least one of the third plate surface 1323 and the fourth plate surface 1324. The mounting opening 1321 penetrates through the third plate surface 1323 and the fourth plate surface 1324. The third plate surface 1323 and the first plate surface 1312 are on the same side of the emitting substrate 13, and the fourth plate surface 1324 and the second plate surface 1313 are on the same side of the emitting substrate 13. The heat conduction member 14 is located on the side of the emitting substrate 13 where the first plate surface 1312 is located.

The first substrate 131 and the second substrate 132 are thin plates, and among their multiple surfaces, the side surfaces are relatively narrow. Therefore, the plate surfaces of the first substrate 131 and the second substrate 132 can be considered as the remaining surfaces excluding the side surfaces. In an embodiment, the first substrate 131 and the second substrate 132 can be regarded as having two relatively arranged plate surfaces, which can be parallel.

The first plate surface 1312 of the first substrate 131 and the third plate surface 1323 of the second substrate 132 can be coplanar or non-coplanar. The second plate surface 1313 of the first substrate 131 and the fourth plate surface 1324 of the second substrate 132 can be coplanar or non-coplanar. The first electrical connection pad 1311 can be arranged on at least one of the first plate surface 1312 and the second plate surface 1313, and the second electrical connection pad 1322 can be arranged on at least one of the third plate surface 1323 and the fourth plate surface 1324.

The thermal expansion coefficient of the heat conduction member 14 is $a$, and the thermal expansion coefficient of the first substrate 131 is b. The emitter 10 satisfies the following condition: 3 ppm/°C $\leq |a - b| \leq 4$ ppm/°C. By reasonably designing the difference between the thermal expansion coefficient of the heat conduction member 14 and the thermal expansion coefficient of the first substrate 131, their thermal expansion coefficients are made relatively close. In this way, the deformation of the heat conduction member 14 and the first substrate 131 after long-term use is similar, ensuring the reliability of the connection between them and making the connection part 1511 less likely to separate.

The thermal expansion coefficient $a$ of the heat conduction member 14 can satisfy: 2 ppm/°C $\leq a \leq 6$ ppm/°C. The thermal expansion coefficient $a$ of the heat conduction member 14 can be 2 ppm/°C, 3 ppm/°C, 4 ppm/°C, 5 ppm/°C, 6 ppm/°C, etc. The thermal expansion coefficient $b$ of the first substrate 131 can satisfy: 6 ppm/°C $\leq b \leq 10$ ppm/°C. The thermal expansion coefficient $b$ of the first substrate 131 can be 6 ppm/°C, 7 ppm/°C, 8 ppm/°C, 9 ppm/°C, 10 ppm/°C, etc.

In an embodiment, the preparation material of the first substrate 131 includes at least one of aluminum nitride, silicon carbide, and copper, and the preparation material of the heat conduction member 14 includes a tungsten-copper alloy. This ensures that the first substrate 131 and the heat conduction member 14 have high thermal conductivity while maintaining relatively close thermal expansion coefficients for reliable connection.

As the thermal expansion coefficient of the heat conduction member 14 is close to that of the first substrate 131, they can be thermally connected using silver paste. Silver paste can be very thin with high thermal conductivity, resulting in a low thermal resistance at the contact interface between the heat conduction member 14 and the first substrate 131. The connection method between the heat conduction member 14 and the first substrate 131 can also be replaced with solder bonding (such as gold-tin bonding, etc.).

The preparation material of the second substrate 132 can include a material known as FR4. In this case, there is a significant difference in thermal expansion coefficients between the second substrate 132 and the heat conduction member 14, and they can be thermally connected using a low-modulus organic silicone soft adhesive (such as epoxy adhesive).

Referring to Figures 21 to 26, both the first substrate 131 and the second substrate 132 can be thermally connected to the heat conduction member 14. The first substrate 131 can be thermally connected to the heat conduction member 14 using silver paste, and the second substrate 132 can be thermally connected to the heat conduction member 14 using organic silicone soft adhesive.

The heat conduction member 14 includes a first main board 1412 and at least one first convex portion 1413 and at least one second convex portion 1414 connected to the first main board 1412. The first main board 1412 is located on the side of the emitting substrate 13 where the laser 11 is arranged, and the first main board 1412 is provided with a light emitting port 1411. The first convex portion 1413 is arranged between the first main board 1412 and the emitting substrate 13 and corresponds to the first substrate 131. The side of the first convex portion 1413 away from the first main board 1412 is thermally connected with the first substrate 131, such as through thermal connection with silver paste. The second convex portion 1414 is arranged between the first main board 1412 and the emitting substrate 13 and corresponds to the second substrate 132. The side of the second convex portion 1414 away from the first main board 1412 is thermally connected with the second substrate 132, such as through thermal connection with organic silicone soft adhesive.

Since the first convex portion 1413 corresponds to the first substrate 131, the first convex portion 1413 is provided with an adhesive such as silver paste, which facilitates the determination of the adhesive application area and improves the efficiency of connection between the heat conduction member 14 and the first substrate 131 through the adhesive. Since the second convex portion 1414 corresponds to the second substrate 132, the second convex portion 1414 is provided with an adhesive such as silver paste, which facilitates the determination of the adhesive application area and improves the efficiency of connection between the heat conduction member 14 and the second substrate 132 through the adhesive.

The heat conduction member 14 can include multiple first convex portions 1413 and multiple second convex portions 1414 arranged at intervals. Each first convex portion 1413 and each second convex portion 1414 can be arranged at intervals, and at least one first convex portion 1413 can be integrally formed with at least one second convex portion 1414.

The heat conduction member 14 can be provided with a first mounting hole 1415 at the portion corresponding to the first convex portion 1413. The first substrate 131 can be provided with a second mounting hole 1314 corresponding to the first mounting hole 1415. The heat conduction member 14 and the first substrate 131 can be connected via a first structural member 21 (refer to Figure 20) passing through the first mounting hole 1415 and the second mounting hole 1314. The arrangement of the first structural member 21 facilitates the assembly and positioning of the heat conduction member 14 and the first substrate 131. The connection between the heat conduction member 14 and the first substrate 131 at the first convex portion 1413 enhances the connection tightness between the first convex portion 1413 and the first substrate 131, improving the heat transfer performance between them. The first structural member 21 can be a positioning post, a screw, etc.

The first structural member 21 can be mounted on the emitting lens 20, or the emitting lens 20 can be provided with a fifth mounting hole corresponding to the first mounting hole 1415 and the second mounting hole 1314, and the first structural member 21 also passes through the fifth mounting hole to facilitate positioning and assembly between the emitter 10 and the emitting lens 20.

A quantity of second mounting holes 1314 on the heat conduction member 14 can be multiple, and the multiple second mounting holes 1314 can be generally distributed on the top and bottom of the heat conduction member 14.

The heat conduction member 14 can be provided with a third mounting hole 1416 at the portion corresponding to the second convex portion 1414. The second substrate 132 can be provided with a fourth mounting hole 1325 corresponding to the third mounting hole 1416. The heat conduction member 14 and the second substrate 132 can also be connected via a second structural member passing through the third mounting hole 1416 and the fourth mounting hole 1325. The arrangement of the second structural member facilitates the assembly and positioning of the heat conduction member 14 and the second substrate 132. The connection between the heat conduction member 14 and the second substrate 132 at the second convex portion 1414 enhances the connection tightness between the second convex portion 1414 and the second substrate 132, improving the heat transfer performance between them. The second structural member can be a positioning post, a screw, etc.

The second structural member can be mounted on the emitting lens 20, or the emitting lens 20 can be provided with a sixth mounting hole 22 corresponding to the third mounting hole 1416 and the fourth mounting hole 1325, and the second structural member also passes through the sixth mounting hole 22 to facilitate positioning and assembly between the emitter 10 and the emitting lens 20. A quantity of fourth mounting holes 1325 on the heat conduction member 14 can be multiple, and the multiple fourth mounting holes 1325 can be generally distributed on the top and bottom of the heat conduction member 14.

In an embodiment, the second structural member is a screw, and the emitting lens 20 is provided with the sixth mounting hole 22. The sixth mounting hole 22 is a threaded hole that matches the screw, allowing for connection between the emitter 10 and the emitting lens 20 through the screw, and increasing the contact tightness between the emitter 10 and the emitting lens barrel near the screw, improving the heat transfer efficiency between them.

The first substrate 131 and the heat conduction member 14 can be integrally formed. In an embodiment, the first electrical connection pad 1311 of the first substrate 131 and the second electrical connection pad 1322 of the second substrate 132 can be arranged corresponding to the light emitting port 1411 on the heat conduction member 14 to facilitate the electrical connection operation between the first electrical connection pad 1311 and the second electrical connection pad 1322.

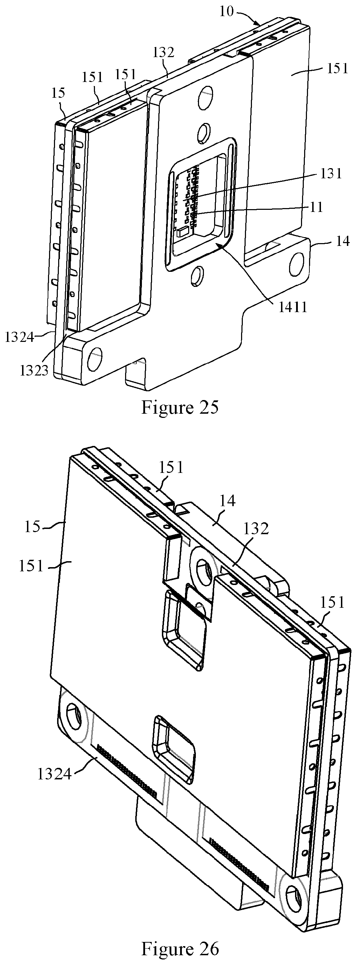

Referring to Figures 25 and 26, the emitter 10 includes an emitting shielding member 15. The emitting shielding member 15 is used to cover the emitting driving circuit 12 on the emitting substrate 13. The emitting shielding member 15 can shield the emitter 10 from the influence of external electromagnetic radiation, while also preventing interference generated during operation of the emitter 10 from propagating outward. The emitting shielding member 15 is made of a metallic material.

The emitting shielding member 15 can include two emitting shielding covers 151. Part of the emitting driving circuit 12 is mounted on the side of the emitting substrate 13 (second substrate 132) where the laser 11 is arranged and is covered by one emitting shielding cover 151. The remaining part of the emitting driving circuit 12 is mounted on the side of the emitting substrate 13 (second substrate 132) away from the laser 11 and is covered by another emitting shielding cover 151. One of the two emitting shielding covers 151, located on the side of the laser 11, can form a bypass hole at the laser 11; or one of the two emitting shielding covers 151, located on the side of the laser 11, can include two sub-emitting shielding covers located on opposite sides of the laser 11.

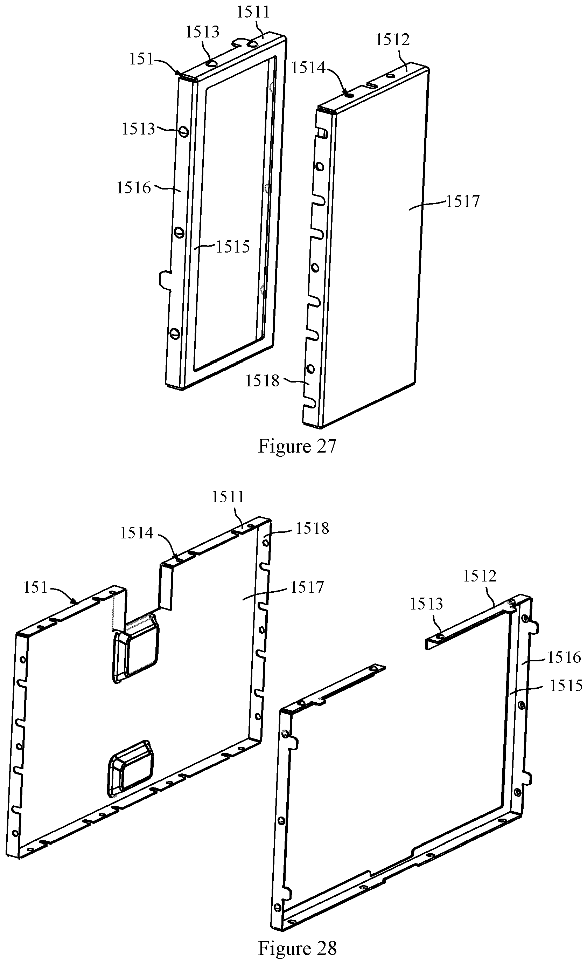

Referring to Figures 27 and 28, the emitting shielding cover 151 includes a connecting portion 1511 and a shielding portion 1512. The connecting portion 1511 is connected to the second substrate 132 and is provided with either a snapping member 1513 or a fastening member 1514. The shielding portion 1512 is provided with the other of the snapping member 1513 and the fastening member 1514, and the snapping member 1513 and the fastening member 1514 are detachably connected. The snap-fit detachable connection between the connecting portion 1511 and the shielding portion 1512 is convenient for assembly and disassembly.

The connecting portion 1511 can include a first connecting plate 1515 and a second connecting plate 1516. The middle portion of the first connecting plate 1515 is hollowed out, and the first connecting plate 1515 is spaced apart from the second substrate 132. One end of the second connecting plate 1516 is connected to the first connecting plate 1515, and the other end of the second connecting plate 1516 is bent relative to the first connecting plate 1515 and extends towards the second substrate 132 for connection with the second substrate 132. The second connecting plate 1516 is provided with either a snapping member 1513 or a fastening member 1514. The second connecting plate 1516 can be arranged corresponding to the edge of the first connecting plate 1515. When there are multiple second connecting plates 1516, different second connecting plates 1516 can be arranged corresponding to different edges of the first connecting plate 1515.

The connection between the connecting portion 1511 and the second substrate 132 can be a snap-fit connection. For example, the first connecting plate 1515 can be provided with either a snap block or a snap slot, and the second substrate 132 is provided with the other of the snap block and the snap slot, allowing for detachable connection.

The shielding portion 1512 can include a first shielding plate 1517 and a second shielding plate 1518. The first shielding plate 1517 is located on the side of the connecting portion 1511 away from the second substrate 132 and covers the connecting portion 1511. One end of the second shielding plate 1518 is connected to the first shielding plate 1517, and the other end of the second shielding plate 1518 is bent relative to the first shielding plate 1517 and extends towards the second substrate 132. The second shielding plate 1518 is provided with the other of the snapping member 1513 and the fastening member 1514. The second shielding plate 1518 can be generally arranged around the periphery of the first shielding plate 1517 to enhance the electromagnetic shielding performance of the emitter 10.

When one of the two emitting shielding covers 151, located on the side of the laser 11, includes two sub-emitting shielding covers, the two sub-emitting shielding covers can also adopt the above-mentioned scheme including a connecting portion 1511 and a shielding portion 1512.

At least a portion of the first shielding plate 1517 of the emitting shielding cover 151 located on the side opposite to the laser 11 can be recessed towards the fourth plate surface 1324 to thermally connect with the fourth plate surface 1324. This increases the thermal connection area between the second substrate 132 and the emitting shielding cover 151 on the side of the fourth plate surface 1324, facilitating heat transfer from the fourth plate surface 1324 side to the emitting shielding cover 151 on the fourth plate surface 1324 side, and improving the heat dissipation performance of the second substrate 132. The recessed portion of the first shielding plate 1517 can correspond to the heat generating device on the second substrate 132, and the recessed portion and the heat generating device on the second substrate 132 can be thermally connected through thermal conductive gel, to improve the heat transfer performance between them.

Referring to Figures 29 to 31, when the heat conduction member 14 includes a first heat conduction plate 141 located between the emitting substrate 13 and the emitting lens 20, and a second heat conduction plate 142 located on the side of the emitting substrate 13 away from the emitting lens 20, the first heat conduction plate 141 and the second heat conduction plate 142 can cover the emitting driving circuit 12 on the emitting substrate 13. Both the first heat conduction plate 141 and the second heat conduction plate 142 can be metal members. Since the first heat conduction plate 141 and the second heat conduction plate 142 are metal members, they can achieve both heat transfer and electromagnetic shielding, eliminating the need for a separate emitting shielding member on the emitter 10, simplifying the structure of the emitter 10.

The first heat conduction plate 141 is located on the side of the emitting substrate 13 where the laser 11 is arranged and avoids the laser 11, such as by providing a light emitting port 1411 corresponding to the laser 11 on the first heat conduction plate 141. The second heat conduction plate 142 is located on the side of the emitting substrate 13 away from the laser 11. Part of the emitting driving circuit 12 is located on the side of the emitting substrate 13 (second substrate 132) where the laser 11 is arranged and is covered by the first heat conduction plate 141. Another part of the emitting driving circuit 12 is located on the side of the emitting substrate 13 (second substrate 132) away from the laser 11 and is covered by the second heat conduction plate 142.

The first heat conduction plate 141 can be thermally connected to the second substrate 132 and the emitting lens 20, transferring the heat generated by the emitting driving circuit 12 on the side of the second substrate 132 where the laser 11 is located to the emitting lens 20, and then dissipating it outward through the emitting lens 20. For example, the aforementioned methods of transferring heat from the emitting lens 20 to the first end plate 310 and the second end plate 320 of the housing 300, and/or directly from the first heat conduction plate 141 to the first end plate 310 and the second end plate 320, etc., can be used.

The second heat conduction plate 142 can be thermally connected to both the first substrate 131 and the second substrate 132, transferring the heat generated by the emitting driving circuit 12 on the side of the second substrate 132 away from the laser 11 and the heat generated by the laser 11 on the first substrate 131 outward. For example, the second heat conduction plate 142 can directly thermally connect with the peripheral side plate 330 of the housing 300 to transfer heat to the peripheral side plate 330, and/or the second heat conduction plate 142 can transfer heat to the emitting lens 20 through the aforementioned emitting heat transfer member 30, and then dissipate it through the emitting lens 20 to the first end plate 310 and the second end plate 320, etc.

The second heat conduction plate 142 includes a second main board 1421 and a third convex portion 1422 mounted on the second main board 1421. The second main board 1421 is located on the side of the emitting substrate 13 away from the laser 11 and covers the emitting driving circuit 12 on that side. The third convex portion 1422 is arranged between the second main board 1421 and the emitting substrate 13 and corresponds to the first substrate 131, thermally connecting with the first substrate 131, such as through thermal connection with silver paste. The second main board 1421 is thermally connected to the second substrate 132, such as through thermal connection with organic silicone soft adhesive (epoxy adhesive, etc.).

The second heat conduction plate 142 can include a fourth convex portion 1423 mounted on the second main board 1421. The fourth convex portion 1423 is arranged on the side of the second main board 1421 away from the emitting substrate 13 and is thermally connected to the peripheral side plate 330 of the housing 300, such as through thermal connection and connection with thermal conductive gel or thermal connection through a thermal pad, etc. The fourth convex portion 1423 can correspond to the first substrate 131.

The thermal expansion coefficient of the second heat conduction plate 142 is c, and the thermal expansion coefficient of the first substrate 131 is b. The emitter 10 can satisfy the following condition: $3 \text{ ppm/°C} \leq |c - b| \leq 4 \text{ ppm/°C}$. By reasonably designing the difference between the thermal expansion coefficient of the second heat conduction plate 142 and the thermal expansion coefficient of the first substrate 131, their thermal expansion coefficients are made relatively close. In an embodiment, the deformation of the second heat conduction plate 142 and the first substrate 131 after long-term use is roughly similar, ensuring the reliability of the connection between them and making the connection parts less likely to separate.

The thermal expansion coefficient c of the second heat conduction plate 142 can satisfy: $2 \text{ ppm/°C} \leq c \leq 6 \text{ ppm/°C}$. The thermal expansion coefficient c of the second heat conduction plate 142 can be 2 ppm/°C, 3 ppm/°C, 4 ppm/°C, 5 ppm/°C, 6 ppm/°C, etc. The thermal expansion coefficient b of the first substrate 131 can satisfy: 6 ppm/°C ≤ $b$ ≤ 10 ppm/°C. The thermal expansion coefficient $b$ of the first substrate 131 can be 6 ppm/°C, 7 ppm/°C, 8 ppm/°C, 9 ppm/°C, 10 ppm/°C, etc.

In an embodiment, the preparation material of the first substrate 131 includes at least one of aluminum nitride, silicon carbide, and copper, and the preparation material of the second heat conduction plate 142 includes a tungsten-copper alloy. This ensures that the first substrate 131 and the second heat conduction plate 142 have high thermal conductivity while maintaining relatively close thermal expansion coefficients for reliable connection.

As the thermal expansion coefficient of the second heat conduction plate 142 is close to that of the first substrate 131, they can be bonded using silver paste. Silver paste can be very thin with high thermal conductivity, resulting in a low thermal resistance at the contact interface between the second heat conduction plate 142 and the first substrate 131. The connection method between the second heat conduction plate 142 and the first substrate 131 can also be replaced with solder bonding (such as gold-tin bonding, etc.).

The preparation material of the second substrate 132 can include a material known as FR4. In this case, there is a significant difference in thermal expansion coefficients between the second substrate 132 and the second heat conduction plate 142, and they can be bonded using a low-modulus organic silicone soft adhesive (such as epoxy adhesive).

The thermal conductivity of the first heat conduction plate 141 can be lower than that of the second heat conduction plate 142. Since the first heat conduction plate 141 is used to transfer the heat generated by the emitting driving circuit 12 on the side of the second substrate 132 where the laser 11 is located, the heat is relatively low. The second heat conduction plate 142 is used to transfer the heat generated by the emitting driving circuit 12 on the side of the second substrate 132 away from the laser 11 and the heat generated by the laser 11 on the first substrate 131, and the heat is relatively high. Therefore, setting the thermal conductivity of the first heat conduction plate 141 lower than that of the second heat conduction plate 142 facilitates timely and efficient outward transfer of heat from high-temperature areas, while maintaining a relatively normal transfer speed for heat in low-temperature areas, thereby reducing the manufacturing cost of the LiDAR 1 while ensuring a high heat dissipation rate.

The first heat conduction plate 141 can be made of a metal heat conduction member such as aluminum, and the second heat conduction plate 142 can be made of a metal heat conduction member such as a tungsten-copper alloy.

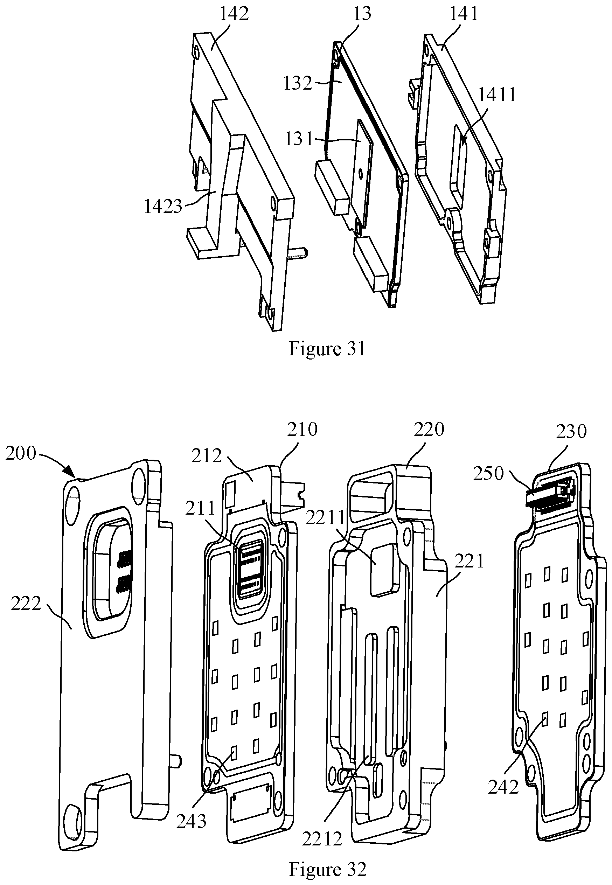

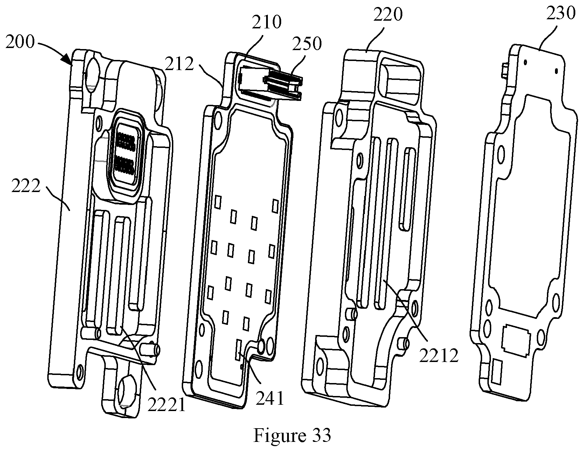

Referring to Figures 32 and 33, the receiving module 200 includes a receiving board 210 and a receiving shielding member 220. The receiving board 210 is used to receive echo light, and the receiving shielding member 220 covers the receiving board 210. The receiving shielding member 220 can shield the receiving board 210 from the influence of external electromagnetic radiation, while also preventing interference generated during operation of the receiving board 210 from propagating outward. The receiving shielding member 220 is made of a metallic material. The thermal connection between the receiving module 200 and the housing 300 can be achieved by the receiving board 210 being thermally connected to the housing 300, or by the receiving board 210 being thermally connected to the receiving shielding member 220 and the receiving shielding member 220 being thermally connected to the housing 300.

In an embodiment, the receiving board 210 is thermally connected to the receiving shielding member 220, and the receiving shielding member 220 is thermally connected to the housing 300, allowing the heat generated by the receiving board 210 to be transferred to the housing 300 through the receiving shielding member 220, such as to the first end plate 310 and the second end plate 320 of the housing 300. The thermal connection between the receiving module 200 and the first end plate 310 and the second end plate 320 can be achieved through a thermal pad, so that the heat on the receiving module 200 can be timely transferred to the first end plate 310 and the second end plate 320 through the thermal pad.

The receiving board 210 includes a receiver 211 and a receiving substrate 212. The receiver 211 is used to receive detection light and is mounted on one side of the receiving substrate 212, such as by being mounted on one side of the receiving substrate 212 using silver paste. The receiving substrate 212 is provided with a metal through hole at the portion corresponding to the receiver 211, allowing the heat generated by the receiver 211 to be transferred to the side of the receiving substrate 212 away from the receiver 211 through the metal through hole. This enables heat dissipation from both the side of the receiving board 210 where the receiver 211 is arranged and the side away from the receiver 211, improving the heat dissipation performance of the receiving board 210.

The receiving shielding member 220 includes a first receiving shielding cover 221. The first receiving shielding cover 221 is arranged on the side of the receiving substrate 212 away from the receiver 211. The side of the first receiving shielding cover 221 close to the receiving substrate 212 is provided with a first convex platform 2211. The first convex platform 2211 corresponds to the receiver 211 and is thermally connected to the receiving substrate 212, such as through thermal connection with thermal conductive gel. This allows the heat on the receiving board 210 to be dissipated through the first convex platform 2211 and the first receiving shielding cover 221 on the side away from the receiver 211. The first receiving shielding cover 221 is thermally connected to the housing 300, such as being thermally connected to both the first end plate 310 and the second end plate 320 of the housing 300.

A first receiving driving circuit 241 is arranged on the side of the receiving substrate 212 away from the receiver 211, and the first receiving shielding cover 221 covers the first receiving driving circuit 241. The side of the first receiving shielding cover 221 close to the receiving substrate 212 is provided with a second convex platform 2212. The second convex platform 2212 corresponds to the heat generating device on the first receiving driving circuit 241 and is thermally connected to the heat generating device, such as through thermal connection with thermal conductive gel. This allows the heat from the heat generating device on the first receiving driving circuit 241 to be dissipated through the second convex platform 2212 and the first receiving shielding cover 221.

The receiving module 200 includes a signal amplification board 230. The signal amplification board 230 is arranged on the side of the first receiving shielding cover 221 away from the receiving substrate 212 and is electrically connected to the receiving board 210. The side of the signal amplification board 230 close to the first receiving shielding cover 221 is provided with a second receiving driving circuit 242, and the first receiving shielding cover 221 also covers the second receiving driving circuit 242. In an embodiment, the receiving shielding member 220 can prevent the signal amplification board 230 from being affected by external electromagnetic radiation, while also preventing interference generated during operation of the signal amplification board 230 from propagating outward.

The first receiving driving circuit 241 can belong to the driving circuit of the receiving board 210 or the driving circuit of the signal amplification board 230. When the first receiving driving circuit 241 belongs to the driving circuit of the signal amplification board 230, a third receiving driving circuit 243 is provided on the side of the receiving substrate 212 where the receiver 211 is arranged. The receiving shielding member 220 further includes a second receiving shielding cover 222. The second receiving shielding cover 222 is arranged on the side of the receiving substrate 212 where the receiver 211 is arranged and covers the third receiving driving circuit 243.

The side of the second receiving shielding cover 222 close to the receiving substrate 212 is provided with a third convex platform 2221. The third convex platform 2221 corresponds to the heat generating device on the third receiving driving circuit 243 and is thermally connected to the heat generating device, such as through thermal connection with thermal conductive gel. This allows the heat from the heat generating device on the third receiving driving circuit 243 to be dissipated through the third convex platform 2221 and the second receiving shielding cover 222. The second receiving shielding cover 222 is thermally connected to the housing 300, such as being thermally connected to both the first end plate 310 and the second end plate 320 of the housing 300.

The electrical connection between the receiving board 210 and the signal amplification board 230 can be achieved through an electrical connector 250. The electrical connector 250 includes a male connector and a female connector that are electrically connected. One of the male connector and the female connector is mounted on the receiving board 210, and the other is mounted on the signal amplification board 230. The first receiving shielding cover 221 can cover the electrical connector 250.

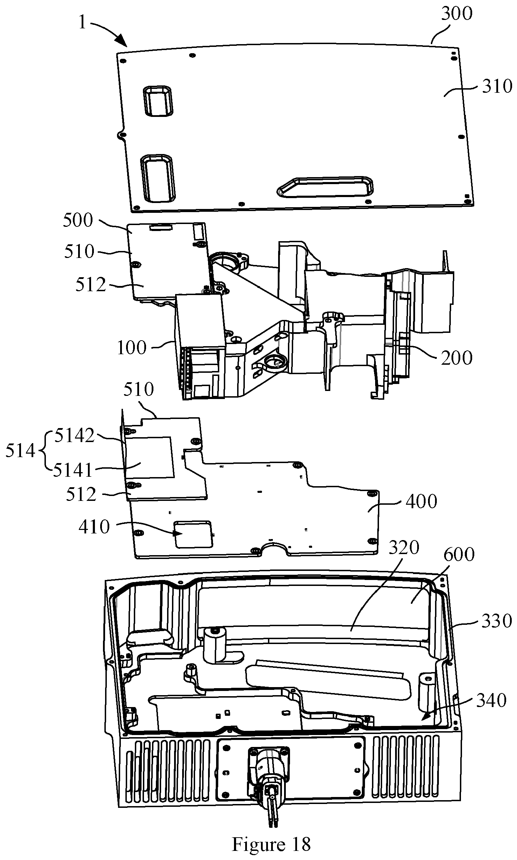

Referring again to Figure 18, the scanning module 500 includes at least one scanning component 510. The scanning component 510 includes a scanner and a control board 512. The scanner is used to transmit detection light and echo light and is mounted on and electrically connected to the control board 512. The scanner can rotate under the drive of the control board 512. The thermal connection between the scanning module 500 and the housing 300 can be achieved by the control board 512 being thermally connected to the housing 300, such as being thermally connected to at least one of the first end plate 310, the second end plate 320, and the peripheral side plate 330 of the housing 300.

In an embodiment, the heat generating device on the control board 512 can be located on one side of the control board 512, and a thermal pad can be arranged on the other side of the control board 512. The thermal pad is thermally connected to the housing 300, so that the heat generated by the heat generating device on the control board 512 can be transferred to the thermal pad and the housing 300 through the metal through holes on the control board 512. The thermal pad can be thermally connected to the first end plate 310 or the second end plate 320 of the housing 300. The control board 512 can be attached to the thermal pad, and the thermal pad can be attached to the first end plate 310 or the second end plate 320. If the control board 512 is arranged close to the first end plate 310, the control board 512 can transfer heat to the first end plate 310 through the thermal pad. If the control board 512 is arranged close to the second end plate 320, the control board 512 can transfer heat to the second end plate 320 through the thermal pad.

In an embodiment, the scanning component 510 can include a scanning shielding member. The scanning shielding member covers the control board 512. The heat generating device on the control board 512 can be thermally connected to the scanning shielding member, such as through thermal connection with thermal conductive gel. The scanning shielding member is thermally connected to the housing 300, so that the heat generated by the heat generating device on the control board 512 can be transferred to the housing 300 through the scanning shielding member. The thermal connection between the scanning shielding member and the housing 300 can be achieved by the scanning shielding member being thermally connected to the peripheral side plate 330 of the housing 300.

The thermal connection between the scanning shielding member and the housing 300 can be achieved by the scanning shielding member being thermally connected to the housing 300 through a scanning heat transfer member 514. The scanning heat transfer member 514 can be made of graphene, which has good thermal conductivity.

The scanning heat transfer member 514 can include a third heat transfer plate 5141 and a fourth heat transfer plate 5142 connected to the third heat transfer plate 5141. The third heat transfer plate 5141 and the fourth heat transfer plate 5142 are arranged at an angle. The third heat transfer plate 5141 is attached and connected to the scanning shielding member, and the fourth heat transfer plate 5142 is attached and connected to the peripheral side plate 330 of the housing 300, increasing the contact area between the scanning shielding member and the housing 300 and improving the heat dissipation performance of the scanning module 500.

In an embodiment, the scanning module 500 includes two scanning components 510. The rotation axes of the scanners of the two scanning components 510 intersect (such as being perpendicular to each other). The control board 512 of one of the scanning components 510 is arranged close to the first end plate 310 and transfers heat to the first end plate 310 through a thermal pad. For example, the heat generated by the heat generating device on one side of the control board 512 is transferred to the thermal pad on the other side of the control board 512 through metal through holes and then transferred to the first end plate 310 through the thermal pad. The control board 512 of the other scanning component 510 is arranged close to the second end plate 320 and transfers heat to the peripheral side plate 330 through the scanning shielding member and the scanning heat transfer member 514. In an embodiment, each of the two scanning components 510 provides control signals through a respective control board 512. Compared to using a single control board, this arrangement offers better heat dissipation performance. The two control boards 512 are thermally connected to different parts of the housing 300, avoiding heat concentration on the housing 300 and further improving the heat dissipation performance.

One of the two scanning components 510 can be a galvanometer scanner, and the other can be a rotating polygon scanner.

In the description of the present application, it should be understood that terms such as "first", "second", etc. are used for descriptive purposes only and should not be construed as indicating or implying relative importance. Those skilled in the art can understand the specific meanings of the above terms in the context of the present application based on specific circumstances.

Additionally, in the description, unless otherwise specified, "multiple" refers to at least two, such as two, three, four, etc. "And/or" describes the association relationship between associated objects and indicates that three possible relationships can exist. For example, "A and/or B" can represent the following three situations: A exists alone, A and B exist simultaneously, or B exists alone. The character "/" generally indicates an "or" relationship between the preceding and following associated objects.

**Claims**

1. An emitter, comprising:

    a laser;
    a driving circuit, wherein the driving circuit is electrically connected to the laser;
    a substrate, wherein the laser and the driving circuit are both mounted on the substrate; and
    a heat conduction member, wherein the heat conduction member is connected to the substrate, and
    a portion of the substrate that is used to mount the laser is in contact with the heat conduction member.

2. The emitter according to claim 1, wherein the substrate comprises:

    a first substrate, wherein the laser is mounted on the first substrate, and the first substrate is in contact with the heat conduction member; and
    a second substrate, wherein the driving circuit is mounted on the second substrate.

3. The emitter according to claim 2, wherein the second substrate is formed with a mounting opening, the first substrate is located in the mounting opening, a thermal expansion coefficient of the second substrate is lower than a thermal expansion coefficient of the first substrate, and the second substrate is in contact with the heat conduction member.

4. The emitter according to claim 2 or 3, wherein the heat conduction member is located on a side of the substrate that is used to set the laser, and the heat conduction member avoids the laser.

5. The emitter according to claim 4, wherein a thermal expansion coefficient of the heat conduction member is $a$, a thermal expansion coefficient of the first substrate is b, and the emitter satisfies the following condition:

$$3 \, \text{ppm/}^\circ\text{C} \leqslant |a - b| \leqslant 4 \, \text{ppm/}^\circ\text{C}.$$

6. The emitter according to claim 4, wherein a preparation material of the first substrate comprises at least one of aluminum nitride, silicon carbide, and copper, and a preparation material of the heat conduction member comprises a tungsten-copper alloy.

7. The emitter according to claim 4, wherein the heat conduction member comprises:

a first main board, wherein the first main board is located on a side of the substrate that is used to set the laser, the first main board is provided with a light emitting port corresponding to the laser, and
at least one first convex portion, wherein the first convex portion is located between the first main board and the substrate, the first convex portion is used to set the first substrate, and the first convex portion is connected to the substrate and is in contact with the first substrate;
at least one second convex portion, wherein the second convex portion is located between the first main board and the substrate, the second convex portion is used to set the second substrate, and the second convex portion is connected to the substrate and is in contact with the second substrate.

8. The emitter according to claim 7, wherein the heat conduction member is provided with a first mounting hole at the first convex portion, the first substrate is provided with a second mounting hole corresponding to the first mounting hole, and a first structural member that passes through the first mounting hole and the second mounting hole is connected to the heat conduction member and the first substrate; or, the heat conduction member is provided with a third mounting hole at the second convex portion, the second substrate is provided with a fourth mounting hole corresponding to the third mounting hole, and a second structural member that passes through the third mounting hole and the fourth mounting hole is connected to the heat conduction member and the second substrate.

9. The emitter according to claim 4, wherein the first substrate and the heat conduction member are integrally formed.

10. The emitter according to claim 2 or 3, wherein the heat conduction member comprises:

a first heat conduction plate, wherein the first heat conduction plate is located on a side of the substrate that is used to set the laser, and the first heat conduction plate avoids the laser; and
a second heat conduction plate, wherein the second heat conduction plate is located on a side of the substrate that is away from the laser, and
a portion of the driving circuit is mounted on a side of the second substrate close to the laser, and is covered by the first heat conduction plate, and a remaining portion of the driving circuit is mounted on a side of the second substrate away from the laser, and is covered by the second heat conduction plate, and
the first heat conduction plate and the second heat conduction plate are both metal members, the first heat conduction plate is in contact with the second substrate, and the second heat conduction plate is in contact with the first substrate and the second substrate.

11. The emitter according to claim 10, wherein a thermal expansion coefficient of the second heat conduction plate is c, a thermal expansion coefficient of the first substrate is b, and the emitter satisfies the following condition:

$$3 \, \text{ppm}/^{\circ}\text{C} \leqslant |c - b| \leqslant 4 \, \text{ppm}/^{\circ}\text{C}.$$

12. The emitter according to claim 10, wherein a preparation material of the first substrate comprises at least one of aluminum nitride, silicon carbide, and copper, and a preparation material of the second heat conduction plate comprises a tungsten-copper alloy.

13. The emitter according to claim 10, wherein the second heat conduction plate comprises:

a second main board, wherein the second main board is located on a side of the substrate that is away from the laser and is covered by the driving circuit, and
a third convex portion, wherein the third convex portion is located between the second main board and the substrate, the third convex portion is used to set the first substrate, and the third convex portion is connected to the first substrate.

14. An emitting module, comprising:

the emitter according to any one of claims 1 to 13; and
an emitting lens, wherein the emitting lens is located on a light emitting side of the laser of the emitter.

15. A LiDAR, comprising:

a housing, wherein the housing is formed with an accommodating cavity;
an emitting module, wherein the emitting module is located in the accommodating cavity, the emitting module is used to output a detection light;
a receiving module, wherein the receiving module is located in the accommodating cavity;
a scanning module, wherein the scanning module is located in the accommodating cavity, the scanning module is used to receive the detection light and to transmit the detection light to a target object, and the scanning module is further used to receive an echo light that is reflected by the target object and is transmitted to the receiving module, and

the emitting module, the receiving module, and the scanning module are in heat conduction connection with different parts of the housing.

Figure 1

Figure 2

Figure 3

Figure 4

Figure 5

Figure 6

Figure 7

Figure 8

Figure 9

Figure 10

Figure 11

Figure 12

Figure 13

Figure 14

Figure 15

Figure 16

Figure 17

Figure 18

Figure 19

Figure 20

Figure 21

Figure 22

Figure 23

Figure 24

Figure 25

Figure 26

Figure 27

Figure 28

Figure 29

Figure 30

Figure 31

Figure 32

Figure 33